# EUROPÄISCHE PATENTANMELDUNG

(11) **EP 4 039 621 A1**
(43) Veröffentlichungstag der Anmeldung: **10.08.2022**
(21) Anmeldenummer: 22155732.5
(22) Anmeldetag: 08.02.2022
(51) Int. Cl.: B65G 49/07, B65G 49/06, B65G 21/20, B65G 54/02, B65G 47/84

(54) **SYSTEM ZUM HALTEN EINES WERKSTÜCKS**

(30) Priorität: 08.02.2021 EP 21155880
(71) Anmelder: ZS-Handling GmbH, 93055 Regensburg (DE)
(72) Erfinder: HAGER, Andreas, 93057 Regensburg (DE); HARTL, Günther, 93197 Zeitlarn (DE); HANSELMANN, Sonja, 93053 Regensburg (DE); SCHILP, Michael, 93053 Regensburg (DE); ZITZMANN, Adolf, 92552 Teunz (DE)
(74) Vertreter: Stellbrink & Partner Patentanwälte mbB

(57) **Zusammenfassung**

Die vorliegende Erfindung betrifft ein System (1) zum Halten eines Werkstücks (6), umfassend eine Translationsschiene (3) und einen ersten Schlitten (4), welcher ein Mitnehmerelement (5) aufweist, wobei das Mitnehmerelement (5) ausgebildet ist, an dem Werkstück (6) zur Anlage zu kommen, wobei der Schlitten (4) an der Translationsschiene (3) angeordnet ist und die Translationsschiene (3) ausgebildet ist, den Schlitten (4) entlang einer Translationsrichtung zu bewegen, wobei das System eine Halteschiene (2) umfasst, wobei die Halteschiene (2) eine Haltefläche (7) aufweist und ausgebildet ist, das Werkstück (6) in einer Translationsebene beabstandet von der Haltefläche (7), insbesondere kontaktlos, zu halten.

## Beschreibung

### Gebiet

Die vorliegende Erfindung betrifft ein System zum Halten eines Werkstücks.

### Hintergrund

In vielen Bereichen müssen flächige Bauteile von einem Ort gegriffen und an einem anderen Ort wieder abgelegt werden. Bei oberflächenempfindlichen Bauteilen sollte dieser Greifprozess besonders schonend oder im besten Fall berührungslos stattfinden.

Bei Solarzellen, Wafern und kleinen Gläsern werden häufig automatisierte sehr schnelle Roboter, meist Stabkinematiken ("Flexpicker") oder SCARA (Selective Compliance Assembly Robot Arm oder Selective Compliance Articulated Robot Arm), eingesetzt, die über eine Bildverarbeitung die Aufnahmeposition und die Ablageposition vermessen, die Positionen nachkorrigieren und taktil auf der Oberfläche mit Bernoulli- und Vakuumgreifern greifen.

Typischerweise weisen diese Systeme folgende Nachteile auf: Es können sehr hohe Beschleunigungen, und damit sehr hohe Belastungen auf die Bauteile auftreten, sodass eine erhöhte Bruchgefahr besteht. Ferner können diese Systeme unproduktive Rückwege eines Greifsystems aufweisen. Zudem können durch die hohen Verfahrgeschwindigkeiten in allen Dimensionen Bauteile anfangen zu schwingen, insbesondere anfangen zu flattern, sodass eine erhöhte Bruchgefahr besteht. Ferner können taktile Greifprinzipien eine Beschädigung der Oberfläche zur Folge haben. Zudem können diese Greifsysteme in nachteiliger Weise hohe bewegte Massen aufweisen.

Alternativ können Werkstücke mittels eines Oberseitenvakuumbands angesaugt und über Reibung an einen Ablageplatz transportiert werden, wo sie wieder abgelegt werden. Hierbei kann jedoch ein

Nachführen der Positionen nur eingeschränkt möglich sein. Insbesondere kann eine Temperaturkompensation nicht realisiert werden. Ferner können Aufnahmeungenauigkeiten während des Transports nicht korrigiert werden. Da ein Oberseitenvakuumband auf einem taktilen Greifprinzip basiert, besteht das Risiko einer Beschädigung der Oberfläche an dem der Greifer in Kontakt mit dem Werkstück ist. Zudem können bei sehr dünnen Bauteilen und hohem Unterdruck Löcher in das Bauteil gestanzt werden und/oder das Bauteil kann unzulässig verformen. Das Vakuumband kann energieintensiv sein, da typischerweise große Luftvolumina bewegt werden, um das Bauteil zu halten.

Die Druckschrift WO2011009447A2 zeigt ein Oberseitentransportsystem, mit dem Bauteile angesaugt werden können und per Ultraschalllager auf Abstand gehalten werden können. Eine Antriebsvorrichtung kann ein umlaufendes Band aufweisen, an dem Mitnehmervorsprünge vorgesehen sind. Die Mitnehmervorsprünge können definiert an einem Rand des Werkstücks angreifen und dieses weiterschieben. Die Mitnehmervorsprünge sind in vorbestimmten Abständen angeordnet.

In dieser Hinsicht wird Bezug genommen auf die Anmeldung WO002011009447A2, deren Inhalt hiermit in diese Anmeldung aufgenommen wird.

Dieses Oberseitentransportsystem weist jedoch durch ein vorgegebenes Formnest in der Länge keine Flexibilität gegenüber der Bauteilgröße auf. Zudem ist keine Kompensationsmöglichkeit bei Längendehnungen vorgesehen. Ein zeitintensives Anfahren jeder einzelnen Position würde zu einer inakzeptablen Reduktion des Durchsatzes führen.

Für den Transport von Gläsern auf Luftlagertischen und auch Ultraschalltischen zur Bearbeitung, Beschichtung und Inspektion sind Systeme bekannt, wo ein seitlicher Linearmotorantrieb das Glas entweder ansaugt, klammert oder mit an einzeln bewegten Linearmotorschlitten bewegten Schiebern positioniert und dadurch weitertransportiert.

Bekannte Systeme dieser Art bilden einen diskontinuierlichen Prozess ab, sodass die Schlitten leer zurückfahren. Dabei kann in nachteiliger Weise eine Reihenfolge der Schlitten nicht verändert werden, da sie alle auf einer Schiene fahren und sie blockieren sich gegenseitig. Jeder Schlitten kann einen Linearmotor darstellen, der mit einem eigenen Kabelschlepp angebunden werden muss. Die Länge der Schlepps ist begrenzt, gleichzeitig ist bei vielen Schlitten die Anzahl der Schlepps ein Platzproblem.

Derartige Aufnahme- und Ablagesysteme haben sich bewährt, weisen allerdings einige Nachteile und Unzulänglichkeiten auf. Insbesondere sind derartige Aufnahme- und Ablagesysteme nicht geeignet eine hohe Präzision bei Aufnahme, Ablage und Transport zu erreichen und gleichzeitig das Werkstück frei von Oberflächenkontakten zu transportieren.

### Zusammenfassung

Im Lichte dessen besteht ein Bedarf nach einem Transportsystem für insbesondere flächig ausgebildete Werkstücke und allgemein nach Pick&Place-Systemen, die Werkstücke kontaktlos und präzise Aufnehmen und ablegen können. Es ist eine Aufgabe der vorliegenden Erfindung, die Unzulänglichkeiten und Nachteile aus dem Stand der Technik zu überwinden bzw. zumindest abzuschwächen. Insbesondere ist es eine Aufgabe der vorliegenden Erfindung, ein System zum Halten eines Werkstücks mit erhöhter Ablagepräzision und minimiertem Werkstückkontakt bereitzustellen, welches vorteilhafterweise den Einsatz in einem weiten Werkstücktemperaturbereich ermöglichen kann.

Diese Aufgaben werden durch das System der vorliegenden Erfindung gelöst.

Die vorliegende Erfindung betrifft ein System und ein Verfahren und ist insbesondere für das Greifen von beispielsweise rechteckigen Substraten mit einer Fläche in dem Bereich von 1 mm² bis 10 m², vorzugsweise in dem Bereich von 25 cm² bis 900 cm² geeignet. Die Substrate können vorteilhafterweise eine Dicke in dem Bereich von 0,01 mm bis 5 mm aufweisen. Ferner können die Substrate von einem Vorprozess über ein, insbesondere auch berührungsloses, Transportband und/oder aus einer Pufferkassette bereitgestellt sein und/oder auf mehrere Plätze eines Matrixtrays, auf Spuren und/oder auf Transportbänder verteilt werden.

Das System kann ausgebildet sein, Wafer, insbesondere Solarwafer, zu transportieren, die auf Matrixtrays für PECVD Prozesse verteilt bzw. von diesen eingesammelt werden sollen. Entsprechend kann ein Solarwafer von einer Aufnahmeposition aufgenommen und an einer Ablageposition abgelegt werden. Hierbei kann das System eine Ablagegenauigkeit von 0,1 mm bis 0,01 mm erreichen.

Ferner kann das System Wafer, die auf mehrere Spuren für einen mehrspurigen Druck- oder Ätzprozess verteilt werden sollen aufnehmen und zu den unterschiedlichen Prozessstufen transportieren. Die Wafer können mehrmals von dem System aufgenommen und abgelegt werden.

Das System ist ferner ausgebildet, Gläser zur Verwendung als Handydisplaygläser oder Gläser zur Verwendung in Displays für Navigationsgeräte, für Tablets, zur Verwendung in Automobilen zu transportieren. Insbesondere können die Gläser auf mehrere Spuren und/oder auch Matrixtrays für Beschichtungs-, Belichtungs-, Belackungs- und Ätzprozesse verteilt werden.

Zudem kann das System geeignet sein Filtergläser vor und nach einem Beschichtungsprozess der Gläser zu transportieren. Auch können Blechteile vor und nach dem Beschichten, Belacken, und/oder Reinigen transportiert werden. Eine weitere Anwendung betrifft den Transport von Gläsern vor oder nach einem Zuschnitt der Gläser. Insbesondere ist ein Transport unabhängig von den Materialeigenschaften des zu transportierenden Substrats möglich.

Diese Substrate können
- heiß sein, also insbesondere im Vergleich zu einer Umgebungstemperatur eine höhere Temperatur aufweisen;
- unterschiedliche Formate haben, also insbesondere unterschiedliche Umrisskanten, Flächeninhalte, Dicken und/oder Längen aufweisen;
- beidseitig berührungsempfindlich oder kratzempfindlich sein; und/oder
- bis zum Rand beschichtet sein, sodass insbesondere keine Randausschlusszonen zum Halten und/oder Transportieren des Substrats vorgesehen sein können.

Entsprechend erreicht das System den Vorteil, dass eine Nutzfläche des zu transportierenden Substrats maximiert werden kann und diese insbesondere von dem System nicht berührt wird.

Die Substrate können für die Berührung an den Substratkanten geeignet sein. Insbesondere können die Kantenflächen der Substrate berührungsunempfindlich sein.

Das System kann ausgebildet sein, eine vorbestimmte Zahl an Transportzyklen pro Zeiteinheit zu erreichen. Beispielsweise können Taktzeiten in einem Bereich von 500-10.000 Substraten pro Stunde erreicht werden.

Das System kann ausgebildet sein, eine vorbestimmte Präzision, mit der die Substrate in die Matrixcarrier oder andere Aufnahmen gelegt werden zu erreichen. Die Substrate können in Taschen gelegt werden, die nur wenige Hundertstelmillimeter größer sind als die Außenabmessungen des Substrats. Entsprechend kann das System ausgebildet sein, das Substrat in eine Tasche abzulegen, wobei ein Abstand zwischen einer Substratkante und einer Tascheninnenkante in einem Bereich von 0,01 mm bis 0,1 mm liegen kann. Auch können diese Taschen bis zu 10 mm tief sein.

Ein Substrat kann von einer Unterlage, z.B. einem Transportband gegriffen werden. Abweichungen bei der Aufnahme können mehrere Millimeter betragen und eine Verdrehung aufweisen. Entsprechend kann das System ausgebildet sein, eine derartige Ungenauigkeit zu kompensieren. Insbesondere kann eine Positionskorrektur des Werkstücks in Bezug auf eine Referenzposition und/oder eine Ablageposition während einer Translation des Werkstücks realisiert sein.

Auf dem Weg zum Zielpunkt, insbesondere einer Ablageposition, kann das Substrat exakt ausgerichtet werden und am Zielpunkt kontrolliert abgesetzt werden. Ein "Fallenlassen" über eine Strecke von bis zu 5 mm kann zulässig sein, solange die Ablagepräzision erreicht werden kann. Entsprechend kann das System ausgebildet sein, eine Haltekraft derart zu skalieren, dass an der Ablageposition zumindest zeitweise ausschließlich die Gewichtskraft des Werkstücks auf das Werkstück einwirkt. Ein Andrücken des Werkstücks, insbesondere an eine Ablagefläche, kann vorteilhafterweise entfallen. Dennoch kann das System ausgebildet sein, die Richtung der Haltekraft umzukehren und zu skalieren, um einen Abstand zwischen Halteschiene und Werkstück aktiv von erhöhen, respektive das Werkstück in Richtung einer Flächennormale einer Haltefläche der Halteschiene zu beschleunigen.

Besonders zu berücksichtigen ist, dass bei der Aufnahme die einströmende Luft zwischen Ablage und Bauteil einen Unterdruck erzeugen kann und die Aufnahme erschwert sein kann, beim Ablegen dagegen die verdrängte Luft ein Luftpolster bilden kann, auf dem das Bauteil seitlich wegschwimmen kann.

Bei heißen Prozessen oder bei stark wechselnden Temperaturen können sowohl die Längen der Bauteile als auch die Dimensionen der Carrier aufgrund von Temperaturdehnungen abweichen. Die Abweichungen können beispielsweise im Millimeterbereich, insbesondere in einem Bereich von 0,1 mm bis 10 mm, liegen. Das System kann ausgebildet sein, dies zu kompensieren.

Das System kann hohe Aufnahme- und Ablagegeschwindigkeiten erreichen. Ferner kann flexibel auf Abweichungen des Werkstücks von einer Aufnahmereferenzposition und/oder Abweichungen der Ablagenische von einer Ablagereferenzposition reagiert werden. Ferner können innerhalb eines Größenbereichs Werkstücke unterschiedlicher Größe aufgenommen werden. DerTransport des Werkstücks kann derart gestaltet werden, dass eine Bruchgefahr des Werkstücks reduziert sein kann. Dies kann insbesondere durch ein vollflächiges Ansaugen des Werkstücks realisiert sein. Entsprechend kann die Bruchgefahr gering sein. Das System kann, insbesondere mittels einer geschlossenen Translationstrajektorie respektive eines endlosen Riemens, einen kontinuierlichen Prozess abbilden, sodass das System keinen unproduktiven Rückweg aufweisen kann. Im Vergleich zu Stabkinematiken oder Robotern weist das System geringe bewegte Massen auf.

Die Vorteile des Überkopfsystems mit Ultraschall und der Präzision und Nachstellbarkeit des Linearmotorsystems sollen kombiniert werden.

Gleichzeitig werden die Nachteile eines Linearmotorsystems gelöst.

Vorteilhafterweise kann eine Schiene des Linearmotorsystems (Translationsschiene) nicht mehr aus den Statormagneten gebildet sein, sondern nimmt die Spulen auf (bspw. ähnlich einem Transrapidsystem, dass für Automatisierung umgesetzt ist). Dies kann beispielsweise ein System von Beckhoff (XTS) und/oder B&R (Apopostrak) sein. Demnach kann eine Translationsschiene Spulen zum elektromagnetischen Antrieb des Schlittens umfassen. Ferner kann der Schlitten Magneten umfassen, um über die Translationsschiene angetrieben zu werden. Der Schlitten kann ferner einen Längenmesssystemgeber umfassen. Damit kann der Schlitten energielos werden und kann ohne Kabelschlepp fahren.

Die einzelnen Schlitten können eine Vorrichtung (beispielsweise einen schmalen Einstellbalken) zur Aufnahme der Randanschläge für die Bauteile tragen. Durch Verfahren der Schlitten zueinander kann ein Formnest in Fahrtrichtung eingestellt werden.

Durch verfahrbare Einstellbalken kann über an diesen taktil abrollende Hebel auch das Formnest seitlich eingestellt werden.

Mehrere Schlitten können gleichzeitig hintereinanderfahren und damit mehrere Wafer parallel picken und positionieren. Die Positionen können im laufenden Betrieb über eine interne Simulation (z.B. Temperaturkompensation) oder über externe Positionsmessverfahren nachgestellt und korrigiert werden.

Bei einer schleifenartigen Konstruktion des Magnetträgers können die Schlitten im Kreis fahren, der Nachteil des unproduktiven Rückwegs ist damit nicht mehr taktzeitrelevant.

Die einzelnen Schlitten können sehr leicht sein. Mit den geringen bewegten Massen können hohe Beschleunigungen und Geschwindigkeiten bei geringem Energieeinsatz realisiert werden.

Ein Vakuumkanal mit unten liegender Sonotrode kann sich über die gesamte Pick&Place-Strecke erstrecken und kann mehrere Pick- (Bernoullidüsen für größere Entfernungen) und Place-Positionen (Abblasdüsen) an geeigneten Positionen aufweisen.

Seitlich parallel kann der Antriebsbalken (Translationsschiene), mit Linearmotoren und einer Führung der Antriebsschlitten (energielos, keine Energiekette) angeordnet sein.

Schwerter (Mitnehmerelemente), beispielsweise Bleche mit einer Dicke in einem Bereich von 1 mm bis 5 mm, können Mitnehmerpins (Sekundäranschlagelemente) tragen und können an den Antriebsschlitten befestigt sein. Mehrere Schwerter (beispielsweise zwei, also vor und hinter dem Transportgut, oder auch an jeder Ecke) bilden ein in Fahrtrichtung (Translationsrichtung) verstellbares Formnest, da die einzelnen Antriebsschlitten synchronisiert gemeinsam, aber auch einzeln verfahren werden können.

Die seitlichen Mitnehmerpins können fix eingestellt oder aber während der Fahrt durch Kulissen oder ähnliche aktive Elemente am Vakuumkanal verstellt werden, z.B. zur Zentrierung und Ausrichtung.

Die Pins können überfedert sein, um eigenständig, aber ohne Fremdenergie in Position zu sein.

Sensoren an den Pick&Place-Positionen können ausgebildet sein, den jeweiligen Vorgang und die Anwesenheit sowie Integrität der Transportgüter zu detektieren und/oder zu überwachen.

Zusätzliche Lager (Führungslager) entlang des Vakuumkanals können die Schwerter führen. Dadurch kann der Vorteil erreicht werden, dass Schwingungen der Mitnehmerelemente unterbunden oder zumindest reduziert werden können.

Temperatursensoren im Vakuumkanal, im Antriebssystem sowie für die Ablagepositionen (Matrixtrays) können die jeweiligen Temperaturen messen, ein Algorithmus kann daraus die veränderten Werte berechnen und kann die temperaturbedingten Längenänderungen in und quer zur Fahrtrichtung kompensieren.

Alternativ oder zusätzlich können die Längenänderungen über Längensensoren oder Bildverarbeitung erfasst werden.

Alternativ kann ein Vakuumkanal mit zwei Antriebssystemen rechts und links, d.h. beidseitig der Halteschiene, ausgerüstet werden, so dass verschiedene Stellen rund um das Werkstück individuell gegriffen werden können.

Alternativ kann ein Antriebssystem auf beiden Seiten mit einem Vakuumkanal ausgerüstet werden, um Pick&place-Prozesse nicht nur mehrfach hintereinander in Fahrtrichtung, sondern auch auf mehreren Spuren parallel durchführen zu können.

Entsprechend kann das System ein schnelles, an den Werkstückoberflächen berührungslos arbeitendes Pick&Place System für flächige Bauteile sein. Es kann aufweisen:
- individuell ansteuerbare, linear verfahrbare Träger (Schlitten) für Mitnehmerpins (Sekundäranschlagelemente) in Fahrtrichtung (Translationsrichtung),
- lokal ansteuerbare, quer zur Fahrtrichtung (Translationsrichtung) wirkende Mitnehmerpins (Sekundäranschlagelemente),

Das System kann ausgebildet sein, das Werkstück schwebend zu führen.

Das Schweben kann aus einer Kombination aus abstoßenden und anziehenden Kräften selbstregelnd eingestellt werden. Insbesondere kann mittels einer der folgenden Kombination eine Haltekraft eingestellt werden:
∘ Ultraschall - Vakuum
∘ Düsenluftlager - Vakuum
∘ Luftfilm - Magnet
∘ Gravitation nach unten - Vakuum nach oben

Durch die einstellbaren und verfahrbaren Mitnehmerpins (Sekundäranschlagelemente) können die Werkstücke während der Fahrt ausgerichtet bzw. zentriert werden.

Extern bedingte Längen- und Positionsänderungen für Pick- und Place-positionen können durch Sensoren erfasst und während der Fahrt nachgeregelt werden.

Die Träger (Schlitten) für die Mitnehmerpins (Sekundäranschlagelemente) können nicht nur eine lineare oszillierende Bewegung mit unproduktivem Rückhub fahren, sondern können durch eine Schleife den Vakuumkanal verlassen und zurück an den Anfangspunkt fahren, wo sie sich wieder einfädeln können.

Gemäß einem Aspekt betrifft die Erfindung ein System zum Halten eines Werkstücks, umfassend einen ersten Schlitten, welcher ein Mitnehmerelement aufweist. Das Mitnehmerelement kann ausgebildet sein, an dem Werkstück zur Anlage zu kommen. Das Randschlagelement kann insbesondere an einer vorbestimmten Fläche des Werkstücks, insbesondere in einem vorbestimmten Bereich einer Fläche des Werkstücks an dem Werkstück zur Anlage kommen. Hierbei kann ein Flächenkontakt oder ein punktförmiger Kontakt zwischen dem Werkstück und dem Mitnehmerelement hergestellt sein. Das Mitnehmerelement kann bei einem Kontakt mit dem Werkstück mit einer vorbestimmten Kraft und/oder mit einer vorbestimmten Beschleunigung auf das Werkstück einwirken. Ein Halten eines Werkstücks kann als ein Aufrechterhalten eines gleichförmigen Bewegungszustands des Werkstücks definiert sein. Hierbei kann das Werkstück eine gleichförmige Translation ausführen. Das Werkstück kann sich zeitweise im Stillstand befinden und/oder beschleunigt werden. Vorzugsweise ist die Translation auf eine Ebene, insbesondere eine vorbestimmte Transportfläche beschränkt. Die Transportfläche kann eine Krümmung aufweisen. Beispielsweise kann die Transportfläche zu einem kontinuierlichen Band geschlossen sein. Vorteilhafterweise kann eine Bewegung des Werkstücks senkrecht zu der Transportfläche zumindest zeitweise unterbunden sein.

Der Schlitten kann in einer weiteren Translationsfläche parallel zu der Translationsfläche des Werkstücks bewegbar angeordnet sein. Insbesondere kann auch eine Bewegung des Schlittens senkrecht zu der weiteren Translationsfläche unterbunden oder zumindest beschränkt sein. Der Schlitten kann zum Halten des Mitnehmerelements ausgebildet sein.

Das Mitnehmerelement kann ausgebildet sein, das Werkstück an einem Punkt zu berühren und über diese Punktberührung vorwärts zu schieben und zu positionieren. Ein Kontakt des Mitnehmerelements kann beispielsweise auch durch seitliches Verschieben des Mitnehmerelements und/oder des ersten Schlittens realisiert sein. Entsprechend kann das Mitnehmerelement zumindest teilweise in einer Richtung senkrecht zu einer Translationsrichtung verschiebbar an dem Schlitten angeordnet sein. Zusätzlich oder alternativ kann der erste Schlitten zumindest teilweise in einer Richtung senkrecht zu einer Translationsrichtung verschiebbar an der Translationsschiene angeordnet sein. Durch eine geeignete Verschiebung können Pick&Place-toleranzen ausgeglichen werden (Öffnen und Schließen eines Formnests durch seitliches Bewegen des Schlittens, respektive des Mitnehmerelements). Die Ablage kann kontrolliert durch Abblasen realisiert sein, wobei die Pins das fallende Bauteil seitlich weiterhin führen können. Entsprechend kann das Mitnehmerelement ausgebildet sein, das Werkstück bei einem Ablegen an einer Ablageposition in einer Richtung senkrecht zur Translationsrichtung, insbesondere in einer Abblasrichtung, zu führen. D.h., das Mitnehmerelement kann Abweichungen des Werkstücks von einer Abblastrajektorie entlang der Abblasrichtung unterbinden oder zumindest minimieren.

Das System erreicht ferner die Vorteile, dass ein Pick&Place-Vorgang mit hoher Geschwindigkeit und Präzision durchgeführt werden kann. Insbesondere können mehrere Werkstückaufnahmen und/oder Werkstückablagen gleichzeitig erfolgen. Eine Oberfläche kann während des gesamten Transportes vollständig berührungslos verbleiben. Durch vollflächiges Ansaugen und berührungsloses Transportieren kann eine Bruchgefahr des Werkstücks minimiert werden. Insbesondere sehr dünne Werkstücke, beispielsweise mit einer Dicke in dem Bereich von 0,01 mm bis 0,1 mm können biegungsfrei, bruchfrei und/oder rissfrei transportiert werden. Zudem kann keine Grenze des Transportwegs existieren, da eine Translationsschiene und/oder eine Halteschiene eine beliebige Länge aufweisen können. Mit geringen Drücken beim Halten des Werkstücks können zudem nur kleine Luftvolumen umgewälzt werden.

Das Werkstück kann auch durch einen Werkstückträger gebildet sein bzw. ersetzt sein. Insbesondere kann der Werkstückträger zur Aufnahme eines Werkstücks ausgebildet sein. Entsprechend kann das Mitnehmerelement ausgebildet sein, an dem Werkstückträger zur Anlage zu kommen. Der Werkstückträger kann ein Formnest zum Halten eines Werkstücks aufweisen. Demnach kann beispielsweise der Werkstückträger, insbesondere mit einem darin aufgenommenen Werkstück, von der Halteschiene beabstandet gehalten werden.

Zusätzlich oder alternativ kann das Werkstück durch eine Verpackung gebildet sein bzw. eine Verpackung umfassen. Insbesondere kann die Verpackung zur Aufnahme eines Werkstücks und/oder eines Werkstückträgers ausgebildet sein. Entsprechend kann das Mitnehmerelement ausgebildet sein, an der Verpackung zur Anlage zu kommen. Die Verpackung kann eine Aufnahme zum Halten eines Werkstücks aufweisen. Demnach kann beispielsweise Die Verpackung, insbesondere mit einem darin aufgenommenen Werkstück, von der Halteschiene beabstandet gehalten werden.

Das System kann eine Translationsschiene umfassen, wobei der Schlitten an der Translationsschiene angeordnet ist. Insbesondere kann der Schlitten bewegbar an der Translationsschiene angeordnet sein. Die Translationsschiene kann ausgebildet sein, eine Bewegung des Schlittens in der weiteren Translationsfläche zu ermöglichen. Die Translationsschiene kann eine Führung für den Schlitten bilden. Insbesondere kann der Schlitten bewegbar an der Translationsschiene angeordnet sein oder bewegbar mit der Translationsschiene verbunden sein. Mit der Translationsschiene kann der Schlitten unabhängig von dem Werkstück bewegt werden. Insbesondere kann eine Anlage des Randanschlagselements an dem Werkstück über eine gesteuerte Bewegung des Schlittens in der weiteren Translationsebene über die Translationsschiene gesteuert werden.

Die Translationsschiene kann ausgebildet sein, den Schlitten mit einer Genauigkeit im Mikrometerbereich zu bewegen. Ferner kann die Translationsschiene ausgebildet sein, den Schlitten zu beschleunigen. Insbesondere kann eine Beschleunigung ohne Werkstückkontakt höher sein, als eine Beschleunigung mit Werkstückkontakt an dem Mitnehmerelement.

Die Translationsschiene kann ausgebildet sein, den Schlitten entlang einer Translationsrichtung zu bewegen. Die Translationsrichtung kann eine Kurve, vorteilhafterweise eine geschlossene Kurve, in der weiteren Translationsebene bilden. Die Translationsrichtung kann geradlinige und/oder gekrümmte Abschnitte aufweisen. Die Translationsrichtung kann parallel zu einem vorbestimmten Pfad des Werkstücks verlaufen. Mit der Bewegung des Schlittens entlang der Translationsrichtung kann auch das Randanschlagselement parallel zu der Translationsrichtung bewegt werden. Ist das Mitnehmerelement mit dem Werkstück zur Anlage gekommen, kann auch das Werkstück parallel zu der Translationsrichtung bewegt werden. Entsprechend kann das Werkstück gehalten werden und entlang der Translationsrichtung oder zumindest parallel zu der Translationsrichtung bewegt werden.

Die Translationsschiene kann ausgebildet sein, den Schlitten in Richtung der Translationsrichtung und/oder entgegengesetzt zu der Translationsrichtung zu bewegen, und/oder wobei die Translationsrichtung eine Krümmung aufweisen kann. Dadurch kann der Vorteil erreicht werden, dass das Werkstück in Richtung der Translationsrichtung transportiert wird und der Schlitten nach Ablage des Werkstücks zu der Ausgangsposition zurückkehren kann. Anschließend kann beispielsweise ein weiteres Werkstück transportiert werden. Mit gekrümmten Abschnitten kann erreicht werden, dass der Schlitten kontinuierlich in eine Richtung bewegt werden kann. Hierbei kann das Werkstück über einen ersten vorbestimmten Abschnitt der Translationsrichtung bewegt werden und anschließend der Schlitten über einen Rückführungsabschnitt der Translationsrichtung an eine Ausgangsposition zurückgeführt werden.

Das System kann eine Halteschiene umfassen, welche ausgebildet ist, das Werkstück zu halten. Die Halteschiene kann das Werkstück kontinuierlich halten. Insbesondere kann das Werkstück unabhängig von einer Position des Werkstücks an der Halteschiene von der Halteschiene gehalten werden. Die Halteschiene kann zumindest teilweise parallel zu der Translationsschiene angeordnet sein. Vorteilhafterweise kann die Halteschiene das Werkstück unabhängig von der Richtung der Gravitationskraft auf das Werkstück halten. Das Werkstück kann zumindest zeitweise während einer Bewegung entlang der Halteschiene unterhalb der Halteschiene angeordnet sein. Hierbei kann eine Anordnung unterhalb der Halteschiene wie folgt definiert sein: Eine Flächennormale der Halteschiene und/oder eine Flächennormale des Werkstücks schließen mit der Gravitationskraft einen Winkel kleiner gleich 90° ein.

Die Halteschiene kann eine Haltefläche aufweisen und kann ausgebildet sein, das Werkstück in der Translationsebene beabstandet von der Haltefläche, insbesondere kontaktlos, zu halten. Dadurch kann der Vorteil erreicht werden, dass eine Seite, insbesondere zumindest eine Fläche des Werkstücks der Halteschiene zugewandt sein kann und die Haltefläche nicht berührt. Das Werkstück kann an der Halteschiene bei Wirken von Kräften (Beschleunigung, Gravitation etc.) auf das Werkstück gehalten werden. Eine der Haltefläche zumindest teilweise zugewandte Fläche des Werkstücks kann mit Projektion entlang einer Flächennormalen der Haltefläche eine vorbestimmte Mindestabdeckung auf der Haltefläche erreichen. Mit anderen Worten kann eine effektive Fläche des Werkstücks, welche parallel zu der Haltefläche ist eine vorbestimmte Mindestgröße aufweisen. Die minimal notwendige Fläche kann von einem Gewicht des Werkstücks abhängig sein.

Das Mitnehmerelement kann ausgebildet sein, an einer Kante des Werkstücks zur Anlage zu kommen. Die Kante kann durch eine Randfläche des Werkstücks gebildet sein. Das Randanschlagselement kann zumindest eine Teilformschlussverbindung mit dem Werkstück bilden. Entsprechend kann zumindest eine Teilfläche des Mitnehmerelements parallel zu einer Teilrandfläche des Werkstücks ausgerichtet sein. Die an dem Werkstück anliegende Teilfläche des Mitnehmerelements kann eine Flächennormale aufweisen, welche mit einer Flächennormale der Haltefläche der Halteschiene einen Winkel in dem Bereich von 90° bis 180° einschließt. Bevorzugt ist die Teilfläche senkrecht zu der Haltefläche und/oder parallel zu der Translationsrichtung ausgerichtet.

Das System kann einen zweiten Schlitten umfassen, welcher ein weiteres Mitnehmerelement aufweist und/oder neben dem ersten Schlitten an der Translationsschiene angeordnet ist. Der erste Schlitten und der zweite Schlitten können ausgebildet sein, dass Werkstück gemeinsam zu führen. Die Schlitten können unabhängig und/oder in Relation zueinander bewegbar sein. Der erste Schlitten und der zweite Schlitten können in Translationsrichtung zueinander ausgerichtet sein. Der erste Schlitten und der zweite Schlitten können entlang eines gleichen Pfades bewegbar sein, sodass der erste Schlitten und der zweite Schlitten versetzt zueinander die gleiche Bewegung ausführen können. Der zweite Schlitten kann entlang der Translationsrichtung beabstandet zu dem ersten Schlitten angeordnet sein.

Das Mitnehmerelement und das weitere Mitnehmerelement können zueinander ausgerichtet sein. Das Randschlagelement und das weitere Randschlagelement können spiegelsymmetrisch zueinander ausgebildet und/oder angeordnet sein. Eine Symmetrieachse kann in der Translationsebene liegen und senkrecht zu der Translationsrichtung ausgerichtet sein.

Das Mitnehmerelement kann eine erste Aufnahmefläche aufweisen. Die Aufnahmefläche kann eine Negativform des Werkstücks bilden. Bei einer glatten und/oder nicht gekrümmten Randfläche des Werkstücks, kann die erste Aufnahmefläche eine ebenso glatte und/oder nicht gekrümmte Fläche sein. Die erste Aufnahmefläche kann zumindest den Dimensionen der der ersten Aufnahmefläche zugewandten Randfläche des Werkstücks entsprechend. Vorteilhafterweise ist eine Achse der ersten Aufnahmefläche größer als eine korrespondierende Achse der Randfläche des Werkstücks. Ist eine Randfläche des Werkstücks beispielsweise rechteckig, dann kann die erste Aufnahmefläche in Länge und/oder Breite ein größeres Rechteck bilden. Ferner kann das Werkstück eine zylinder- oder kugelförmige Randfläche aufweisen. Hier kann die erste Aufnahmefläche eine Krümmung mit gleichem oder größerem Radius aufweisen.

Die erste Aufnahmefläche kann zu einer Kante des Werkstücks, insbesondere parallel zu einer Kante des Werkstücks, ausgerichtet sein. Vorteilhafterweise verläuft die Kante des Werkstücks senkrecht zu einer Flächennormale der ersten Aufnahmefläche. Dadurch kann der Vorteil erreicht werden, dass das Werkstück bei Kontakt mit der ersten Aufnahmefläche seine ursprüngliche Orientierung nicht verändert. Insbesondere kann ein Drehen und/oder Kippen des Werkstücks relativ zu der Haltefläche unterbunden oder zumindest reduziert sein.

Eine Flächennormale der ersten Aufnahmefläche kann parallel zu einer Translationsrichtung des ersten Schlittens verlaufen. Dadurch kann der Vorteil erreicht werden, dass mit einer Bewegung des ersten Schlittens und einer entsprechenden Anlage des Mitnehmerelements, insbesondere über die erste Aufnahmefläche, an dem Werkstück, dieses in Translationsrichtung bewegt werden kann. Hierbei kann insbesondere eine Bewegung des Werkstücks in von der Translationsrichtung abweichende Richtungen unterbunden oder zumindest minimiert sein.

Die erste Aufnahmefläche als Vertiefung, insbesondere als eine rechteckige Vertiefung, in dem Mitnehmerelement ausgebildet ist. Die Vertiefung kann in entgegen der Translationsrichtung ausgebildet sein. Dadurch kann das Randschlagelement das Werkstück an einer ersten Kante vollständig und an angrenzenden Kanten zumindest teilweise umschließen bzw. an den angrenzenden Kanten teilweise zur Anlage kommen. Ferner kann durch die rechteckige Vertiefung eine Translation senkrecht zur Translationsrichtung begrenzt sein. Zudem kann eine Rotation des Werkstücks, insbesondere eine Rotation um eine Flächennormale der Haltefläche, respektive einer zur Haltefläche ausgerichteten Fläche des Werkstücks unterbunden oder zumindest begrenzt sein. Eine Breite der Vertiefung kann größer gleich einer Breite der Kante des Werkstücks sein. Alternativ kann die Vertiefung abgerundete, angeschrägte oder trapezförmige Seitenkanten aufweisen.

Das weitere Mitnehmerelement kann eine zweite Aufnahmefläche aufweisen. Die erste Aufnahmefläche und die zweite Aufnahmefläche können ein Formnest bilden, um das Werkstück an gegenüberliegenden Werkstückkanten zu halten. Hierzu kann die erste Aufnahmefläche einem Kantenabbild einer der ersten Aufnahmefläche zugewandten Kante des Werkstücks entsprechen. D.h. die erste Aufnahmefläche kann eine Negativform einer Kante des Werkstücks bilden. Ferner kann die zweite Aufnahmefläche einem weiteren Kantenabbild einer der zweiten Aufnahmefläche zugewandten weiteren Kante des Werkstücks entsprechen. D.h. die zweite Aufnahmefläche kann eine Negativform einer weiteren Kante des Werkstücks bilden. Die Kante und die weitere Kante des Werkstücks können Kantenabschnitte einer kontinuierlichen Kante oder Kantenflächenabschnitte sein, insbesondere Kantenflächenabschnitte einer kontinuierlichen Kantenfläche. Die Kantenfläche kann Ecken oder eine kontinuierliche Krümmung aufweisen.

Das Mitnehmerelement und das weitere Mitnehmerelement können in Bezug auf die Translationsrichtung spiegelbildlich identisch zueinander ausgebildet sein. Dadurch kann der Vorteil erreicht werden, dass ein zumindest bezüglich der Kanten und/oder Kantenflächen symmetrisches Werkstück gehalten werden kann. Hierbei kann eine Symmetrie lediglich an den der ersten Aufnahmefläche und der zweiten Aufnahmefläche zugewandten Kanten des Werkstücks vorliegen.

Das Formnest kann einen Aufnahmebereich für das Werkstück bilden, wobei das Formnest zumindest teilweise eine Umrisskante des Werkstücks abbildet und/oder ausgebildet ist, an einem Punkt des Werkstücks zur Anlage zu kommen. Dadurch kann der Vorteil erreicht werden, dass das Werkstück durch das Formnest in einer vorbestimmten Ausrichtung gehalten werden kann. Ferner kann durch das Formnest eine Position des Werkstücks relativ zu der Halteschiene, insbesondere relativ zu der Haltefläche realisiert werden. Entsprechend kann das Werkstück bei Kontakt mit dem Formnest relativ zu der Halteschiene und/oder relativ zu der Haltefläche bewegt werden.

Der erste Schlitten kann ein Montageelement aufweisen, welches ausgebildet ist, das Mitnehmerelement zu halten. Dadurch kann der Vorteil erreicht werden, dass das Mitnehmerelement mittels des Montageelements lösbar an dem ersten Schlitten angeordnet ist. Beispielsweise kann das Montageelement mit dem Mitnehmerelement eine Formschluss- und/oder eine Kraftschlussverbindung bilden. Das Montageelement kann einen Adapter zwischen einem Translationsmodul und dem Mitnehmerelement bilden. Das Translationsmodul kann ausgebildet sein, den Schlitten an der Translationsschiene entlang zu bewegen. Das Montageelement kann eine Ausrichtung des Mitnehmerelements in Bezug auf das Translationsmodul bestimmen. Ferner kann eine Ausrichtung des Randanschlagselements über das Montageelement justierbar sein, um eine Ausrichtung der ersten Aufnahmefläche zu dem Werkstück einzustellen.

Das Montageelement und das Mitnehmerelement können formschlüssig, kraftschlüssig und/oder trennbar miteinander verbunden sein. Beispielsweise können das Montageelement und das Mitnehmerelement miteinander verschraubt sein.

Der zweite Schlitten kann ein weiteres Montageelement aufweisen, welches ausgebildet ist, das weitere Mitnehmerelement zu halten. Das weitere Montageelement und das weitere Mitnehmerelement können formschlüssig, kraftschlüssig und/oder trennbar miteinander verbunden sein.

Der erste Schlitten kann ein Sekundäranschlagelement umfassen, welches ausgebildet sein kann, an dem Werkstück zur Anlage zu kommen. Wenn die erste Anlagefläche an einer ersten Kante bzw. Kantenfläche des Werkstücks zur Anlage kommt, dann kann das Sekundäranschlagelement an einer weiteren Kante bzw. weiteren Kantenfläche des Werkstücks zur Anlage kommen. Die weitere Kante bzw. die weitere Kantenfläche kann ein Kantenabschnitt der ersten Kante sein bzw. die weitere Kantenfläche kann ein Kantenflächenabschnitt der Kantenfläche sein. Mit dem Sekundäranschlagelement kann erreicht werden, dass eine Translation des Werkstücks in zwei Raumrichtungen und/oder eine Rotation des Werkstücks in einer Ebene unterbunden oder zumindest beschränkt ist.

Das Sekundäranschlagelement kann in einer Halteposition fixiert sein. Insbesondere kann das Sekundäranschlagelement relativ zu dem Mitnehmerelement fixiert sein. Die Halteposition des Sekundäranschlagelements kann anpassbar ausgelegt sein. Dadurch kann Beispielsweise ein Abstand des Sekundäranschlagelements zu einer gegenüberliegenden Fläche des Mitnehmerelements angepasst werden. Entsprechend kann eine Breite der ersten Aufnahmefläche durch das Sekundäranschlagelement veränderbar sein. Eine Breite der ersten Aufnahmefläche kann senkrecht zu der Translationsrichtung definiert sein.

Das Sekundäranschlagelement kann ein Federelement aufweisen, welches ausgebildet ist, das Sekundäranschlagelement gegenüber dem Mitnehmerelement gefedert, insbesondere überfedert, beweglich zu lagern. Dadurch kann der Vorteil erreicht werden, dass das Werkstück mit einer Federkraft beaufschlagt werden kann, um das Werkstück an dem Mitnehmerelement zu fixieren. Durch die gefederte Lagerung kann das Mitnehmerelement an eine Breite des Werkstücks anpassbar sein.

Das Sekundäranschlagelement kann ausgebildet sein, das Werkstück an einer Werkstückkante zu halten. Das Werkstück kann ausschließlich an einer dem Sekundäranschlagelement zugewandten Werkstückkante oder in Kombination an einer der ersten Aufnahmefläche zugewandten Werkstückkante gehalten werden. Entsprechend kann das Sekundäranschlagelement an einer Kante des Werkstücks zur Anlage kommen.

Das Sekundäranschlagelement kann eine Sekundärhaltefläche aufweisen, welche zu einer Kante des Werkstücks, insbesondere parallel zu einer Kante des Werkstücks, ausgerichtet ist. Das Sekundäranschlagelement kann demnach einen Linien-, Punkt- oder Flächenkontakt mit dem Werkstück bilden. Eine Tangente des Werkstückumfangs kann einen Schnittpunkt oder eine Schnittlinie mit der Sekundärhaltefläche bilden. Dadurch kann der Vorteil erreicht werden, dass das Werkstück in einer Ebene fixiert werden kann.

Die Sekundärhaltefläche und die erste Aufnahmefläche können in einer Translationsebene winklig zueinander, insbesondere rechtwinklig zueinander angeordnet sein. Dies erreicht den Vorteil, dass insbesondere Werkstücke mit einem entsprechenden Kantenverlauf von der ersten Aufnahmefläche und der Sekundärhaltefläche gehalten werden können. Die Sekundärhaltefläche kann eine Flächennormale aufweisen, welche einen Winkel mit der Translationsrichtung einschließt, insbesondere einen Winkel in dem Bereich im Bereich von 1°-90°.

Eine Kante des Werkstücks kann durch einen Kantenpunkt gebildet sein, um das Werkstück an einer gekrümmten Kante zu halten. Beispielsweise kann das Werkstück eine gekrümmte Umfangskante aufweisen, die an einem Punkt an der Sekundärhaltefläche und/oder an der ersten Aufnahmefläche anliegt. Das Werkstück kann ferner eine gekrümmte Umfangsfläche aufweisen, welche an einem Punkt (bei doppelter Krümmung) oder an einer Linie (bei einfacher Krümmung) an der Sekundärhaltefläche und/oder an der ersten Aufnahmefläche anliegt.

Die Sekundärhaltefläche kann gekrümmt ausgebildet sein, um einer gekrümmten Kantenkontur des Werkstücks zu folgen. Dadurch kann der Vorteil erreicht werden, dass eine Kontaktfläche oder eine Kontaktlinie zwischen Werkstück und der Sekundärhaltefläche vergrößert sein kann.

Eine erste Projektion der Sekundärhaltefläche projiziert auf eine erste Projektionsebene, welche eine Flächennormale parallel zur Translationsrichtung aufweist, einen Flächeninhalt größer Null, um eine Abstützung des Werkstücks bezüglich Beschleunigungskräften mit und/oder entgegengesetzt zu der Translationsrichtung zu erreichen. Entsprechend kann die Sekundärhaltefläche eine effektive Teilfläche aufweisen, welche senkrecht zu der Translationsrichtung ausgerichtet ist. Dadurch kann das Werkstück bei einer Beschleunigung in Translationsrichtung von der Sekundärhaltefläche gestützt werden, um ein Verschieben des Werkstücks relativ zu dem Mitnehmerelement bzw. dem ersten Schlitten zu unterbinden oder zumindest zu begrenzen.

Eine zweite Projektion der Sekundärhaltefläche projiziert auf eine zweite Projektionsebene mit einer Flächennormale, welche senkrecht zur Translationsrichtung und parallel zu einer Werkstückkante verläuft, einen Flächeninhalt größer Null, um eine Abstützung des Werkstücks entgegen von Beschleunigungskräften senkrecht zur Translationsrichtung zu erreichen. Damit kann die Sekundärhaltefläche eine weitere effektive Teilfläche aufweisen, welche parallel zu der Translationsrichtung ausgerichtet ist. Dadurch kann das Werkstück bei einer Beschleunigung in der Translationsebene, aber abweichend von der Translationsrichtung von der Sekundärhaltefläche gestützt werden, um ein Verschieben des Werkstücks relativ zu dem Mitnehmerelement bzw. dem ersten Schlitten zu unterbinden oder zumindest zu begrenzen.

Das Sekundäranschlagelement kann quaderförmig ausgebildet sein. Dadurch kann der Vorteil erreicht werden, dass das Sekundäranschlagelement auf der ersten Haltefläche gleitend bewegt werden kann und/oder das zwischen der Sekundärhaltefläche und der ersten Haltefläche ein rechter Winkel eingeschlossen ist.

Eine Dicke des Sekundäranschlagelements kann in Richtung einer Flächennormale der Sekundärhaltefläche kleiner sein als eine weitere Dicke der des Sekundäranschlagelements senkrecht zu der Flächennormale und senkrecht zu der Längsrichtung des Sekundäranschlagelements. Entsprechend kann das Sekundäranschlagelement einen Quader bilden. Das Sekundäranschlagelement kann derart an dem Mitnehmerelement angeordnet sein, dass Deckflächen des Quaders mit Randflächen des Mitnehmerelements abschließen.

Das System kann ein weiteres Sekundäranschlagelement umfassen, welches ausgebildet ist, an dem Werkstück zur Anlage zu kommen. Mit dem Sekundäranschlagelement und dem weiteren Sekundäranschlagelement kann das Werkstück an gegenüberliegenden Kanten des Werkstücks gehalten werden. Die gegenüberliegenden Werkstückkanten können einen Winkel kleiner gleich 90° einschließen (beispielsweise auch in virtueller Verlängerung der Kanten des Werkstücks). Entsprechend kann das Werkstück mittels Reibung an dem Kontakt zwischen Werkstück und den Sekundäranschlagelementen und/oder mittels eines Drucks an dem Kontakt zwischen Werkstück und den Sekundäranschlagelementen gehalten werden. Insbesondere kann das Werkstück ausschließlich an der Sekundärhaltefläche des Sekundäranschlagelements und einer weiteren Sekundärhaltefläche des Weiteren Sekundäranschlagelements gehalten werden. Hierbei kann vorteilhafterweise kein weiterer Kontakt zu dem Mitnehmerelement bestehen. Beispielsweise kann das Werkstück beabstandet von der Aufnahmefläche an dem Mitnehmerelement angeordnet sein.

Das weitere Sekundäranschlagelement kann eine weitere Sekundärhaltefläche aufweisen, welche zu einer Kante des Werkstücks, insbesondere parallel zu einer Kante des Werkstücks, ausgerichtet ist, wobei die Sekundärhaltefläche und die weitere Sekundärhaltefläche ausgebildet sind, an gegenüberliegenden Seiten des Werkstücks zur Anlage zu kommen. Das weitere Sekundäranschlagelement und das Sekundäranschlagelement können spiegelsymmetrisch zueinander ausgebildet sein, wobei eine Symmetrieebene die Translationsrichtung einschließt.

Die Sekundärhaltefläche und die weitere Sekundärhaltefläche können parallel zueinander ausgerichtet sein. Dadurch kann beispielsweise der Vorteil realisiert werden, dass das Werkstück in einem Winkel, insbesondere senkrecht, zur Translationsrichtung mittels der Sekundärhalteflächen gehalten werden kann.

Die Sekundärhaltefläche und die weitere Sekundärhaltefläche können spiegelbildlich symmetrisch zueinander, insbesondere winklig zueinander, ausgerichtet sein. Dadurch kann der Vorteil erreicht werden, dass das Werkstück an den Sekundärhalteflächen mit symmetrisch wirkenden Kräften beaufschlagt werden kann.

Das Sekundäranschlagelement kann relativ zu dem Mitnehmerelement, insbesondere entlang einer Positionierachse, verschiebbar an dem Mitnehmerelement angeordnet sein. Die Positionierachse kann beispielsweise senkrecht zu der Translationsachse ausgerichtet sein. Ferner kann die Positionierachse parallel zu der ersten Haltefläche verlaufen. Damit kann das Sekundäranschlagelement entlang der ersten Haltefläche verschiebbar angeordnet sein.

Das Mitnehmerelement kann ein Positionierelement aufweisen, welches ausgebildet ist, auf Basis einer externen Krafteinwirkung auf das Positionierelement das Sekundäranschlagelement zu verschieben, insbesondere entlang der Positionierachse zu verschieben. Das Positionierelement kann mit dem Sekundäranschlagelement verbunden sein und/oder gefedert an dem Sekundäranschlagelement gelagert sein. Ferner kann das Positionierelement und das Sekundäranschlagelement über ein Gewinde verbunden sein. Das Positionierelement und das Sekundäranschlagelement können an dem Mitnehmerelement beweglich gelagert sein. Insbesondere kann das Positionierelement mit dem Sekundäranschlagelement durch einen Führungskanal in dem Mitnehmerelement miteinander verbunden sein. Die externe Krafteinwirkung kann eine Drehung und/oder eine Verschiebung des Positionierelements bewirken.

Das Positionierelement kann ausgebildet sein, das Sekundäranschlagelement während einer Bewegung des ersten Schlittens entlang der Translationsrichtung zu verschieben. Beispielsweise kann Mit dem Positionierelement eine Führung des Werkstücks gesteuert werden. Dadurch kann eine kontinuierliche Nachregelung der Anlage des Werkstücks an der Sekundärhaltfläche realisiert sein, sodass das Werkstück stets Kontakt zu der Sekundärhaltefläche hat. Entsprechend kann ein Verrutschen oder unkontrolliertes Anschlagen des Werkstücks an dem Mitnehmerelement unterbunden oder zumindest reduziert sein. Das Sekundäranschlagelement und/oder das Positionierelement können ausgebildet sein auf das Werkstück wirkende Beschleunigungskräfte aufzunehmen oder zu dämpfen. Eine entsprechende Kraftaufnahme und/oder Dämpfung kann in Positionierrichtung, Translationsrichtung oder einer vektoriellen Summe dieser Richtungen realisiert sein.

Das Positionierelement kann ausgebildet sein, das Sekundäranschlagselement in Bezug auf einen Referenzpunkt zu verschieben, um das Werkstück in Bezug auf den Referenzpunkt auszurichten und/oder zu zentrieren. Diese Verschiebung kann auf Basis einer vorbestimmten Federspannung und/oder vorbestimmten Masse des Werkstücks bestimmt sein. Zusätzlich oder alternativ kann das Positionierelement mittels eines Positionssensors und/oder gegebenenfalls mittels einer Motorsteuerung derart angesteuert werden, dass der Referenzpunkt erreicht werden kann. Das Werkstück kann dabei um eine oder mehrere Achsen senkrecht zur Translationsrichtung gedreht und/oder verschoben werden.

Das weitere Sekundäranschlagelement kann relativ zu dem Mitnehmerelement, insbesondere entlang einer Positionierachse, verschiebbar an dem Mitnehmerelement angeordnet sein. Entsprechend können das Sekundäranschlagelement und das weitere Sekundäranschlagelement ausgebildet sein an dem Werkstück zur Anlage zu kommen und mit Kontakt zu dem Werkstück das Werkstück zu positionieren. Hierbei kann eines der Sekundäranschlagelemente aktiv gesteuert werden und das verbleibende Sekundäranschlagelement kann passiv beweglich gelagert sein. Beispielsweise gleitend in einer Führung gelagert sein und/oder mit einer Federkraft beaufschlagt sein. Eine Federkraft des Sekundäranschlagelements und/oder des Weiteren Sekundäranschlagelements kann mittels einer Spiralfeder und/oder einer Elastomerfeder realisiert sein.

Das Mitnehmerelement kann ein weiteres Positionierelement aufweisen, welches ausgebildet ist, auf Basis einer externen Krafteinwirkung auf das weitere Positionierelement das weitere Sekundäranschlagelement entlang der Positionierachse zu verschieben. Insbesondere kann eine Verschiebung mittels des weiteren Sekundäranschlagelements an eine Verschiebung mittels des Sekundäranschlagelements gekoppelt sein. Eine externe Kraft kann beispielsweise auch eine Motorkraft sein oder auch durch ein Einschieben des Werkstücks in oder an die erste Aufnahmefläche erzeugt sein. Beispielsweise kann das Werkstück an den Sekundäranschlagelementen entlang gleiten und diese verschieben. Hierbei kann mit fortschreitender Verschiebung der Sekundäranschlagelemente eine zwischen der jeweiligen Sekundäraufnahmefläche und der anliegenden Werkstückkante wirkende Kraft proportional erhöht sein. Alternativ kann mittels der Federung eine über die Verschiebung nahezu konstante Kraft realisiert sein. Mit vorsehen eines einzelnen Sekundäranschlagelements, kann die Kraft über das einzelne Sekundäranschlagelement erzeugt werden. Hierbei kann mit einer Ausführung der ersten Aufnahmefläche als rechteckige Vertiefung eine korrespondierende Kraft zwischen der ersten Aufnahmefläche und dem Werkstück wirken.

Das System kann einen Hebel umfassen, welcher ausgebildet ist, an dem Positionierelement zur Anlage zu kommen und das Positionierelement entlang der Positionierachse zu verschieben. Mit dem Hebel kann eine Übersetzung einer auf den Hebel wirkenden Kraft auf das Positionierelement und entsprechend auf das Sekundäranschlagelement realisiert sein. Hierbei kann beispielsweise mit einer Hebelbewegung ein dazu proportionaler Verschiebungsweg des Sekundäranschlagelements realisiert sein. Damit kann mit einem gegebenenfalls automatischen Betätigen des Hebels das Werkstück an dem Mitnehmerelement gehalten, gelagert oder fixiert sein.

Der Hebel kann an der Halteschiene und/oder der Translationsschiene angeordnet sein. Dadurch kann an einer vorbestimmten Position der Halteschiene und/oder der Translationsschiene ein Halten des Werkstücks an dem Mitnehmerelement bewirkt werden.

Der Hebel kann ausgebildet sein taktil abzurollen, um an dem Positionierelement zur Anlage zu kommen. Dadurch kann der Vorteil erreicht werden, dass der Hebel und das Positionierelement eine vordefinierte mechanische Kopplung ausführen. Hierbei kann mit einer Bewegung des ersten Schlittens ein vordefiniertes Bewegungs- und/oder Kraftwirkungsprofil des Hebels, des Positionierelements und entsprechend auch des Sekundäranschlagelements realisiert sein. Damit ein Zeitprofil einer über das Sekundäranschlagelement auf das Werkstück wirkende Kraft gesteuert werden. Alternativ kann mit einer Bewegung des Schlittens in Translationsrichtung über Form und Position des Positionierelements und/oder des Hebels ein Kopplungsablauf zwischen Werkstück und Mitnehmerelement zeitlich und/oder in Bezug auf die wirkenden Kräfte gesteuert werden. Ein taktiles Abrollen kann beispielsweise derart realisiert sein, dass der Hebel rollend gelagert oder mit einer Rolle an dem Mitnehmerelement zur Anlage kommt, wobei eine Kraft über die Anlagefläche (Anlagelinie, Anlagepunkt) von Dem Hebel auf das Positionierelement einem vordefinierten Kraftprofil folgt. Ferner kann die Anlage des Hebels an dem Positionierelement derart gesteuert werden, dass der Hebel mit einer minimalen initialen Kraft auf das Positionierelement wirkt nachdem sich der Kontakt zwischen dem Hebel und dem Positionierelement gebildet hat und/oder mit einer minimalen abschließenden Kraft auf das Positionierelement wirkt, bevor sich der Kontakt zwischen dem Hebel und dem Positionierelement löst.

Das System kann einen weiteren Hebel umfassen, welcher ausgebildet ist, an dem weiteren Positionierelement zur Anlage zu kommen und das weitere Positionierelement entlang der Positionierachse zu verschieben. Entsprechend kann mit einem Zusammenwirken des Hebels und des weiteren Hebels ein Halten des Werkstücks gesteuert werden.

Der weitere Hebel kann an der Halteschiene und/oder der Translationsschiene angeordnet sein. Der Hebel und der weitere Hebel können symmetrisch zueinander angeordnet sein, sodass über den Hebel und den weiteren Hebel gleiche Kräfte auf das Positionierelement wirken. Die Position des Hebels und/oder des weiteren Hebels kann einstellbar sein, um ein Halten des Werkstücks über das Sekundärhalteelement und/oder das weitere Sekundärhalteelement einzustellen.

Der weitere Hebel kann ausgebildet sein taktil abzurollen, um an dem weiteren Positionierelement zur Anlage zu kommen.

Die Translationsschiene kann ausgebildet sein, den ersten Schlitten in Richtung einer Translationsrichtung zu bewegen. Der Schlitten kann rollend und/oder gleitend an der Translationsschiene gelagert sein. Alternativ kann der Schlitten an einem beweglichen Träger der Translationsschiene fixiert sein.

Die Translationsschiene kann ausgebildet sein, den ersten Schlitten und den zweiten Schlitten in Richtung einer Translationsrichtung zu bewegen, wobei ein Abstand zwischen dem ersten Schlitten und dem zweiten Schlitten in Translationsrichtung konstant ist. Dadurch kann der Vorteil erreicht werden, dass das Werkstück in einem Formnest konstanter Größe bewegt werden kann.

Der erste Schlitten und der zweite Schlitten können zueinander in einem Abstand positionierbar sein, um eine erste Länge des Formnestes in Fahrtrichtung des ersten Schlittens und des zweiten Schlittens zu definieren. Dadurch kann der Vorteil erreicht werden, dass das Formnest auf unterschiedliche Längen von Werkstücken anpassbar sein kann. Insbesondere kann die relative Position der Schlitten zueinander zwischen Transportvorgängen automatisch einstellbar sein, um im kontinuierlichen Transportablauf unterschiedlich lange Werkstücke zu transportieren.

Der erste Schlitten kann ein Trägerelement umfassen, wobei das Montageelement an dem Trägerelement angeordnet ist. Dadurch kann der Vorteil erreicht werden, dass das Montageelement modular austauschbar mit dem Trägerelement verbindbar ist.

Das Montageelement kann verschiebbar, insbesondere in Translationsrichtung verschiebbar, an dem Trägerelement angeordnet sein. Damit kann beispielsweise über ein Verschieben des Montageelements eine Position des Mitnehmerelements relativ zu dem Trägerelement anpassbar sein.

Das System kann eine Mehrzahl von Schlitten umfassen, welche in einer Reihe an der Translationsschiene angeordnet sind. Die Translationsschiene kann ausgebildet sein, die einzelnen Schlitten der Mehrzahl von Schlitten hintereinander in einer Reihe entlang der Translationsrichtung zu bewegen. Das System kann insbesondere den ersten Schlitten und einen zweiten Schlitten umfassen, wobei der erste Schlitten und der zweite Schlitten ausgebildet sein können, das Werkstück zu halten und die Translationsschiene ausgebildet sein kann, den ersten Schlitten und den zweiten Schlitten mit gleichbleibendem Abstand der Schlitten zueinander, zu bewegen.

Die Translationsschiene kann ausgebildet sein, die Schlitten der Mehrzahl von Schlitten zueinander gleichförmig zu bewegen und/oder die Schlitten paarweise gleichförmig zueinander zu bewegen. Ein Werkstück kann mittels eines einzelnen Schlittens oder durch ein Paar von Schlitten bewegt werden. Bei einer paarweisen Konfiguration kann ein erster Schlitten in Translationsrichtung vor dem Werkstück und ein zweiter Schlitten in Translationsrichtung hinter dem Werkstück angeordnet sein. Hierbei ist insbesondere das jeweilige Mitnehmerelement der Schlitten in Translationsrichtung vor respektive hinter dem Werkstück angeordnet.

Jeweils zwei Schlitten der Mehrzahl von Schlitten können ausgebildet sein, ein Werkstück zu halten und sich synchron, insbesondere mit gleichbleibendem Abstand zueinander, zu bewegen. Dadurch kann das Werkstück in einem Formnest gleichleibender Größe in Translationsrichtung verschoben werden. Alternativ können zwei Mitnehmerelemente mittels eines einzelnen Schlittens das Werkstück führen. Der erste Schlitten und der zweite Schlitten können mechanisch miteinander gekoppelt sein. Alternativ kann eine synchrone Bewegung der Schlitten durch eine entsprechende elektronische Steuerung und/oder Regelung der Bewegung der Schlitten realisiert sein.

Die Translationsschiene kann ausgebildet sein, den ersten Schlitten auf einer geschlossenen Bahn zu bewegen.

Die Bahn kann in einer ersten Raumrichtung abschnittsweise gerade und/oder abschnittsweise gekrümmt sein. Vorteilhafterweise kann ein Werkstück entlang eines geraden Abschnitts mittels des Schlittens transportiert werden.

Die Bahn kann in einer zweiten Raumrichtung abschnittsweise gerade und/oder abschnittsweise gekrümmt sein. Dadurch kann der Vorteil erreicht werden, dass sich der Schlitten in einer Ebene bewegt. Insbesondere kann dadurch eine gekrümmte Translation des Werkstücks unterbunden werden, da sich auch das Werkstück auf einer Bahn in einer Ebene bewegen kann.

Das System kann einen Sensor umfassen, welcher ausgebildet sein kann, eine physikalische Messgröße als Sensordaten zu erfassen. Beispielsweise kann eine Temperatur erfasst werden. Beispielsweise eine Temperatur des Werkstücks, eine Temperatur des Schlittens und/oder eine Temperatur des Mitnehmerelements etc. Ferner kann eine Länge, ein Abstand und/oder eine Position erfasst werden. Insbesondere kann eine Länge des Werkstücks, eine Länge der ersten Aufnahmefläche und/oder eine Länge des Mitnehmerelements erfasst werden. Damit kann der Vorteil erreicht werden, dass in Abhängigkeit von einem Umgebungsparameter geometrische Veränderungen des Systems erfasst werden können. Beispielsweise können durch Erwärmung des Systems vorbestimmte Abmessungen, Spaltmaße und/oder Abstände variieren. Insbesondere kann das System durch Abwärme von Prozessstufen an dem Aufnahmeort und/oder dem Ablageort des Werkstücks und/oder durch Abwärme von dem Werkstück selbst erwärmt werden. Mit zunehmender Erwärmung kann ein Anpassen der Position des Schlittens und/oder des Sekundäranschlagelements realisiert sein, um das Werkstück innerhalb vorgegebener Toleranzen zu bewegen.

Das System kann ein Steuermodul umfassen, welches ausgebildet sein kann, eine Position des Schlittens, insbesondere eine Position auf der Translationsschiene, anzupassen. Insbesondere kann die Position in Abhängigkeit von der erfassten physikalischen Messgröße anpassbar sein. Das Steuermodul kann die Position regeln oder nach Maßgabe erwarteter Ausdehnung die Position nachsteuern.

Das Steuermodul kann ausgebildet sein, die relative Position des ersten Schlittens in Bezug auf weitere auf der Schiene angeordnete Schlitten mittels einer relativen Translation des ersten Schlittens bezüglich zumindest eines weiteren Schlittens anzupassen. Dadurch kann der Vorteil erreicht werden, dass beispielsweise paarweise angeordnete Schlitten zuverlässig das Werkstück halten können. Insbesondere können Umgebungseinflüsse durch eine relative Translation der Schlitten zueinander ausgeglichen werden. Ferner können Toleranzen zwischen unterschiedlichen Werkstücken bei aufeinanderfolgenden Transporten dieser unterschiedlichen Werkstücke ausgeglichen werden.

Das Steuermodul kann ausgebildet sein, die Position des ersten Schlittens in einem kontinuierlichen Bereich auf der Translationsschiene zu variieren, um einen beliebigen Abstand zwischen zwei an der Translationsschiene zueinander angrenzend angeordneten Schlitten einzustellen. Dadurch kann insbesondere ein Abstand der Schlitten auf eine Werkstücklänge eingestellt werden.

Das Steuermodul kann ausgebildet sein, die Positionsanpassung des Schlittens unabhängig von einer weiteren Bewegung des Schlittens entlang der Translationsschiene auszuführen. Entsprechend kann eine Anpassung auch während einer überlagerten Translation des Schlittens in Translationsrichtung realisiert sein.

Das Steuermodul kann ausgebildet sein, die Position des Schlittens auf Basis der Sensordaten anzupassen. Hierbei kann eine indirekte Steuerung erfolgen, d.h. die Position des Schlittens wird in Abhängigkeit von den Sensordaten variiert um in Bezug auf die Sensordaten angenommene Veränderungen auszugleichen. Alternativ kann die Steuerung direkt erfolgen, d.h. dass eine Stellgröße derart nachgeregelt wird, dass auf einen vorbestimmten Referenzwert geregelt wird. Beispielsweise kann eine Temperatur erfasst werden, wobei daraufhin beispielsweise ein Abstand zwischen Mitnehmerelement und Werkstück geregelt wird.

Das Steuermodul kann ausgebildet sein, eine Simulation durchzuführen um Simulationsdaten zu erzeugen und anhand der Simulationsdaten die Position des Schlittens auf der Schiene anzupassen. Die Simulation kann beispielsweise eine Temperaturkompensation sein, bei einer Expansion aufgrund von Erwärmung oder eine Kontraktion aufgrund von Abkühlung durch eine Verschiebung von Komponenten relativ zueinander ausgeglichen werden kann. Entsprechend kann das System unabhängig von wechselnden Temperaturen gleichbleibend hohe Genauigkeiten bei dem Transport von Werkstücken erreichen.

Das System kann einen Positionsmesssensor aufweisen, welcher ausgebildet ist, Positionsdaten des Schlittens zu erfassen und das Steuermodul kann ausgebildet sein, anhand der Positionsdaten die Position des Schlittens anzupassen, um eine ursprünglich eingestellte Position nachzustellen. Dadurch kann beispielsweise ein Drift des Schlittens über eine Mehrzahl von Verfahrwegen ausgeglichen werden, um den Schlitten an einer Referenzposition oder auf einer Referenztrajektorie zu halten

Die Simulation kann eine Temperaturkompensation umfassen. Unter Temperaturkompensation kann ein Verfahren umfassen, das ein Korrigieren oder Entgegenwirken gegen einen unerwünschten Temperatureinfluss umfasst. Dadurch können Auswirkungen einer Temperaturänderung auf das Aufnehmen, Transportieren und/oder Ablegen des Werkstücks eliminiert oder zumindest reduziert werden.

Die Halteschiene kann ein Anziehungselement, insbesondere einen Vakuumkanal umfassen, welches ausgebildet ist, auf das Werkstück eine zumindest teilweise entgegen einer Flächennormale der Haltefläche gerichtete Kraft auf das Werkstück auszuüben. Das Anziehungselement kann ausgebildet sein, das Werkstück, insbesondere an einer dem Anziehungselement zugewandten Fläche des Werkstücks, mit einer Haltekraft zu beaufschlagen. Die Haltekraft kann zumindest teilweise entgegen der Gewichtskraft des Werkstücks an dem Werkstück angreifen. Das Anziehungselement kann ausgebildet sein, zwischen dem Werkstück und einer Haltefläche der Halteschiene einen Unterdruck zu erzeugen.

Die Halteschiene kann ein Abstoßungselement aufweisen, welches ausgebildet ist, auf das Werkstück eine zumindest teilweise in Richtung einer Flächennormale der Haltefläche gerichtete Kraft auf das Werkstück auszuüben. Beispielsweise kann das Abstoßungselement ein Luftpolster erzeugen.

Das Abstoßungselement kann eine Sonotrode umfassen, welche ausgebildet ist, eine Ultraschallwelle zu erzeugen, um das Werkstück beabstandet an der Halteschiene zu halten. In Kombination mit dem Vakuumkanal kann in einem vorbestimmten Abstand des Werkstücks von der Haltefläche der Halteschiene ein Kräftegleichgewicht hergestellt werden, sodass das Werkstück in einem vordefinierten Abstand von der Haltefläche gehalten werden kann.

Die Sonotrode kann in das Anziehungselement, insbesondere den Vakuumkanal integriert sein. Insbesondere kann eine Schallwandlerfläche der Sonotrode einen Teil der Haltefläche bilden und/oder der Vakuumkanal kann eine Austrittsöffnung in der Haltefläche aufweisen. Der Vakuumkanal kann ferner eine Mehrzahl von Austrittsöffnungen aufweisen, welche die Haltefläche durchsetzen. Ein Werkstück kann insbesondere in Abhängigkeit von einer Länge des Werkstücks von einer vorbestimmten Anzahl von Austrittsöffnungen angeströmt werden.

Das Anziehungselement kann eine Länge aufweisen, welche einem Verfahrabschnitt entspricht, über welchen das Werkstück bewegbar ist, um das Werkstück mittels der Schlitten von einer ersten Position zu einer zweiten Position zu bewegen. Ferner kann das Anziehungselement über die gesamte Länge der Halteschiene vorgesehen sein, um einen kontinuierlichen Transport des Werkstücks zu ermöglichen. Der Verfahrabschnitt kann mit einer Aufnahme des Werkstücks an einer Aufnahmeposition beginnen und/oder mit einer Ablage des Werkstücks an einer Ablageposition enden.

Das Anziehungselement, insbesondere der Vakuumkanal, kann ausgebildet sein, das Werkstück während des Bewegens von der ersten Position zu der zweiten Position kontinuierlich kontaktlos zu halten. Insbesondere kann eine über das Anziehungselement auf das Werkstück wirkende Haltekraft während des Bewegens konstant sein.

Die Translationsschiene kann parallel zu der Halteschiene angeordnet sein. Entsprechend kann das Werkstück und zumindest der erste Schlitten auf parallelen Trajektorien bewegt werden.

Die Translationsschiene kann entlang eines Verfahrwegs des Werkstücks parallel zu der Halteschiene, insbesondere seitlich parallel zu der Halteschiene, angeordnet sein.

Der erste Schlitten kann ausgebildet sein, von der Translationsschiene passiv geführt zu werden. Die Translationsschiene kann Mittel zum Bewegen des Schlittens umfassen, sodass eine Antriebskraft auf den Schlitten wirkt. Der Schlitten kann motorisch, pneumatisch, elektrodynamisch, magnetostatisch oder in einer Kombination dieser Antriebsmöglichkeiten mittels der Translationsschiene bewegt werden.

Das Anziehungselement kann eine Bernoullidüse (auch Venturi-düse) umfassen, welche ausgebildet sein kann, einen Unterdruck zwischen dem Werkstück und der Haltefläche zu erzeugen. Wenn ein Gas durch die Bernoullidüse fließt kann an einer Position innerhalb der Düse mit minimalem Querschnitt der dynamische Druck (Staudruck) maximal und der hydrostatische Druck minimal sein. Die Geschwindigkeit des Gases steigt im Verhältnis der Querschnitte beim Einströmen in den Teil mit minimalem Querschnitt an, da durch die Düse dieselbe Masse pro Zeit hindurchfließt. Entsprechend kann der Druck in einem Abnahmerohr, das sich im Teil mit minimalem Querschnitt befindet. Damit entsteht ein Differenzdruck, der zum Ansaugen genutzt werden kann.

Die Sonotrode kann ausgebildet sein, eine Ultraschallwelle zu erzeugen, um das Werkstück kontaktlos beabstandet an der Haltefläche zu halten. Mit der Ultraschallwelle kann ein Druck erzeugt werden, welcher der Anziehung durch das erzeugte Vakuum (Unterdruck) entgegenwirkt.

Das Anziehungselement kann eine Abblasdüse umfassen, welche ausgebildet sein kann, den Luftdruck zwischen Werkstück und Vakuumkanal zu erhöhen, um das Werkstück von einer Halteposition in eine Ablageposition zu bewegen. Die Ablageposition kann in Bezug auf die Halteposition einen größeren Abstand zu dem Anziehungselement, insbesondere der Haltefläche, aufweisen. Die Abblasdüse kann das Werkstück in Richtung der Ablageposition beschleunigen. Insbesondere kann das Werkstück in eine passgenaue Werkstückaufnahme abgelegt werden. Mit dem erhöhten Luftdruck kann eine effektive Kraft entlang einer Flächennormale der Haltefläche auf das Werkstück wirken.

Das Mitnehmerelement kann aus einem Blech hergestellt sein.

Das Blech kann eine Dicke in einem Bereich von 0,1 mm bis 10 mm, vorzugsweise in einem Bereich von 1 mm bis 5 mm, aufweisen. Insbesondere kann die Dicke des Blechs derart ausgewählt werden, dass eine Kante des Werkstücks zuverlässig an der Anlagefläche zur Anlage kommen kann.

Das Mitnehmerelement kann ausgebildet sein, an einer ersten Ecke des Werkstücks zur Anlage zu kommen. Eine Ecke des Werkstücks kann durch einen Kantenabschnitt parallel zur Translationsrichtung und durch einen weiteren Kantenabschnitt senkrecht zur Translationsrichtung gebildet sein. Das Mitnehmerelement kann ausgebildet sein, an dem Werkstück an dem Kantenabschnitt und/oder an dem weiteren Kantenabschnitt zur Anlage zu kommen.

Das weitere Mitnehmerelement kann ausgebildet sein, an einer weiteren Ecke des Werkstücks zur Anlage zu kommen, wobei die weitere Ecke der ersten Ecke gegenüberliegt und/oder wobei die Ecke und die weitere Ecke jeweils einen Kantenabschnitt parallel zur Translationsrichtung und einen weiteren Kantenabschnitt senkrecht zur Translationsrichtung aufweisen.

Das System kann einen Positionssensor umfassen, welcher an einer Aufnahmeposition der Halteschiene angeordnet sein kann, wobei der Positionssensor ausgebildet ist, die Anwesenheit eines Werkstücks an der Aufnahmeposition zu erfassen und/oder zu überwachen.

Der Positionssensor kann ausgebildet sein, die Integrität des Werkstücks zu erfassen und/oder zu überwachen. Die Integrität des Werkstücks kann unter anderem die Einstückigkeit, Temperaturhomogenität, Rissbildung, Fragmentierung, Biegung, Oberflächenbeschaffenheit, Rauheit und/oder Kantenform umfassen.

Die Halteschiene kann ein Führungslager aufweisen, welches ausgebildet sein kann, das Mitnehmerelement zu führen und/oder zu halten, um ein Schwingen des Mitnehmerelements während einer Bewegung zu dämpfen und/oder zu unterbinden. Dadurch kann eine Übertragung von Vibrationen von dem Schlitten auf das Werkstück unterbunden oder zumindest reduziert sein. Ferner kann eine vom Schlitten auf das Werkstück wirkende Beschleunigung gedämpft sein. Insbesondere kann das Führungslager ausgebildet sein, einen Beschleunigungsgradient zu ändern. Hierbei kann eine initiale Beschleunigung reduziert sein. Ferner können Beschleunigungen unterhalb eines Beschleunigungsgrenzwerts gedämpft werden, sodass diese Beschleunigungen nicht auf das Werkstück wirken.

Der Vakuumkanal kann einen ersten Temperatursensor umfassen, welcher ausgebildet sein kann, eine Temperatur des Werkstücks zu erfassen. Die Temperaturdaten können Basis der Temperaturkompensation sein. Der Temperatursensor kann insbesondere ausgebildet sein, die Temperatur kontaktlos zu erfassen.

Die Translationsschiene kann einen zweiten Temperatursensor umfassen, welcher ausgebildet sein kann, eine Temperatur des Werkstücks zu erfassen.

Der erste Temperatursensor kann ausgebildet sein, die Temperatur des Werkstücks an einer Werkstückaufnahmeposition zu erfassen.

Der Vakuumkanal kann einen dritten Temperatursensor umfassen, welcher ausgebildet sein kann, die Temperatur des Werkstücks an einer Werkstückablageposition zu erfassen.

Die Werkstückaufnahmeposition und die Werkstückablageposition können in Translationsrichtung beabstandet voneinander angeordnet sein.

Das Steuermodul kann ausgebildet sein, Temperaturmessdaten von einem Temperatursensor zu empfangen und die Position des ersten Schlittens und/oder des Mitnehmerelements in Translationsrichtung auf Basis der Temperaturmessdaten zu ändern. Ferner kann das Steuermodul ausgebildet sein, einen Temperaturgradienten von der Werkstückaufnahmeposition zu der Werkstückablageposition zu erfassen. Insbesondere kann das Steuermodul ausgebildet sein, die Position des ersten Schlittens kontinuierlich auf Basis des Temperaturgradienten zu ändern.

Die Temperaturmessdaten können die Temperatur des Werkstücks, zumindest eines Teils der Translationsschiene, zumindest eines Teils der Halteschiene, einer Werkstückablage, insbesondere eines Matrixcarriers, und/oder einer Werkstückaufnahme betreffen.

Das Steuermodul kann ausgebildet sein, eine Längenausdehnung des Werkstücks, zumindest eines Teils derTranslationsschiene, zumindest eines Teils der Halteschiene, einer Werkstückablage und/oder einer Werkstückaufnahme auf Basis der Temperaturmessdaten zu berechnen, um eine temperaturbedingte Längenänderung, insbesondere durch eine Bewegung des ersten Schlittens, zu kompensieren. Entsprechend kann eine Temperaturkompensation nicht nur auf Basis des Werkstücks, sondern auch auf Basis von Komponenten des Systems realisiert sein.

Das Steuermodul kann ausgebildet sein, Temperaturmessdaten von einem Temperatursensor zu empfangen und eine Position des Sekundäranschlagelements auf Basis der Temperaturmessdaten zu verändern, um eine temperaturbedingte Längenänderung des Werkstücks zu kompensieren.

Das Steuermodul kann ausgebildet sein, Längenänderungsdaten von einem Längensensor und/oder einem Bildverarbeitungsmodul zu empfangen und die Position des ersten Schlittens und/oder des Mitnehmerelements in Translationsrichtung auf Basis der Längenmessdaten zu ändern, um eine Längenänderung des Werkstücks zu kompensieren.

Das Steuermodul kann ausgebildet sein, Längenmessdaten von einem Längensensor und/oder einem Bildverarbeitungsmodul zu empfangen und eine Position des Sekundäranschlagelements auf Basis der Längenmessdaten zu verändern, um eine Längenänderung des Werkstücks zu kompensieren.

Das System kann eine weitere Translationsschiene umfassen, wobei die Translationsschiene seitlich an der Halteschiene angeordnet sein kann, und wobei die weitere Translationsschiene seitlich und gegenüberliegend der Translationsschiene an der Halteschiene angeordnet sein kann, um die Halteschiene zwischen der Translationsschiene und der weiteren Translationsschiene anzuordnen.

Das System kann eine weitere Halteschiene umfassen, wobei die Translationsschiene seitlich an der Halteschiene angeordnet sein kann, und wobei die weitere Halteschiene seitlich und gegenüberliegend der Halteschiene an der Translationsschiene angeordnet sein kann, um die Translationsschiene zwischen der Halteschiene und der weiteren Halteschiene anzuordnen.

Die Halteschiene kann ein Düsenluftlagerelement aufweisen, wobei das Düsenluftlagerelement ausgebildet sein kann, das Werkstück von der Haltefläche abzustoßen.

Der Vakuumkanal kann ausgebildet sein, das Werkstück zu der Haltefläche hin anzuziehen.

Das System kann ein Steuermodul umfassen, welches ausgebildet sein kann, den Vakuumkanal und das Düsenluftlagerelement derart zu steuern, dass das Werkstück in einem Abstand zu der Haltefläche gehalten wird.

Das System kann ein Steuermodul umfassen, welches ausgebildet sein kann, den Vakuumkanal und die Sonotrode derart zu steuern, dass das Werkstück in einem Abstand zu der Haltefläche gehalten wird.

Die Halteschiene kann ein Luftfilmelement aufweisen, wobei das Luftfilmelement ausgebildet ist, einen Luftfilm zwischen dem Werkstück und der Haltefläche zu erzeugen.

Die Halteschiene kann ein Magnetelement umfassen, welches ausgebildet sein kann, das Werkstück magnetisch in Richtung der Haltefläche zu ziehen.

Das System kann ein Steuermodul umfassen, welches ausgebildet sein kann, das Luftfilmelement und das Magnetelement derart zu steuern, dass das Werkstück in einem Abstand zu der Haltefläche gehalten wird.

Das System kann ein Steuermodul umfassen, welches ausgebildet sein kann, den Vakuumkanal derart zu steuern, dass das Werkstück in einem Abstand zu der Haltefläche gehalten wird, wobei die Gravitation der durch den Vakuumkanal erzeugten Haltekraft entgegenwirkt.

In Richtung der Translationsrichtung kann eine Aufnahmeposition, an welcher das Werkstück durch das System aufnehmbar ist, und eine Ablageposition an welcher das Werkstück durch das System ablegbar ist, definiert sein.

Das System kann ein Steuermodul umfassen, welches ausgebildet sein kann, Sensordaten zu empfangen, welche eine Positionsänderung der Aufnahmeposition und/oder eine Positionsänderung der Ablageposition anzeigen, und wobei das Steuermodul ferner ausgebildet ist, den ersten Schlitten auf Basis der Sensordaten zu verschieben, um eine zu der Aufnahmeposition und/oder der Ablageposition kongruente Schlittenposition zu erreichen, respektive das Formnest zu dem Werkstück auszurichten.

Das Mitnehmerelement kann ausgebildet sein, das Werkstück gegen Beschleunigungskräfte abzustützen.

Das Mitnehmerelement kann ausgebildet sein, drucklos an dem Werkstück zur Anlage zu kommen.

Das System kann ein Steuermodul umfassen, wobei das Steuermodul ausgebildet sein kann, das Mitnehmerelement mittels Bewegung des ersten Schlittens an dem Werkstück zur Anlage zu bringen und das Auftreten einer Klemmkraft zwischen Werkstück und Mitnehmerelement zu unterbinden.

Das System kann ein Steuermodul umfassen, wobei das Steuermodul ausgebildet sein kann, das Sekundäranschlagelement mittels Bewegens des Hebels an dem Werkstück zur Anlage zu bringen und das Auftreten einer Klemmkraft zwischen dem Werkstück und dem Sekundäranschlagelement zu unterbinden.

Das Mitnehmerelement kann ausgebildet sein, in eine Ausnehmung des Werkstücks einzugreifen. Dadurch kann der Vorteil erreicht werden, dass Kanten des Werkstücks vollständig frei von einem Kontakt mit dem Mitnehmerelement sind. Insbesondere können während eines Transports des Werkstücks die Außenkanten eines Werkstücks frei von Kontakten mit Elementen des Systems sein. Das Mitnehmerelement kann vorteilhafterweise keine Kontaktfläche mit einer Werkstückaußenkante und/oder einer umlaufenden Abschlussfläche des Werkstücks bilden. Eine Werkstückaußenkante oder Abschlussfläche des Werkstücks kann beispielsweise eine dem Mitnehmerelement zumindest teilweise zugewandte Kante oder Fläche sein.

Das Mitnehmerelement kann ausgebildet sein, zumindest teilweise an einer Innenkante der Ausnehmung zur Anlage zukommen. Entsprechend kann das Mitnehmerelement in einer Richtung winklig, insbesondere senkrecht, zur Translationsrichtung bewegbar ausgebildet zu sein, um in eine Ausnehmung des Werkstücks einzugreifen. Die Ausnehmung kann vollständig geschlossen sein. Das Mitnehmerelement kann eine Formschlussverbindung mit der Ausnehmung bilden. Ferner kann das Mitnehmerelement ausgebildet sein, über eine Kontaktfläche oder Kontaktkante des Werkstücks eine Beschleunigung auf das Werkstück zu übertragen. Die Ausnehmung kann durch ein Loch oder eine Vertiefung in dem Werkstück gebildet sein. Das Mitnehmerelement kann die Ausnehmung durchsetzen.

Die Erfindung wird anhand der folgenden nummerierten Ausführungsformen näher beschrieben.

Im Folgenden werden Systemausführungsformen besprochen. Diese Ausführungsformen werden mit dem Buchstaben "S", gefolgt von einer Zahl, abgekürzt. Immer, wenn hier auf "Systemausführungsformen" Bezug genommen wird, sind diese Ausführungsformen gemeint.
S1. System (1) zum Halten eines Werkstücks (6), umfassend einen ersten Schlitten (4), welcher ein Mitnehmerelement (5) aufweist, wobei das Mitnehmerelement (5) ausgebildet ist, an dem Werkstück (6) zur Anlage zu kommen.
S2. System (1) gemäß der vorstehenden Ausführungsform, wobei das Mitnehmerelement (5) ein Randanschlagelement ist, welches ausgebildet ist, an einer Kante des Werkstücks zur Anlage zu kommen.
S3. System (1) gemäß einer der vorstehenden Ausführungsform, umfassend eine Translationsschiene (3), wobei der Schlitten (4) an der Translationsschiene (3) angeordnet ist.
S4. System (1) gemäß einer der vorstehenden Ausführungsformen mit Merkmalen von S3, wobei die Translationsschiene (3) ausgebildet ist, den Schlitten (4) entlang einer Translationsrichtung (10) zu bewegen.
S5. System (1) gemäß einer der vorstehenden Ausführungsformen mit Merkmalen von S4, wobei die Translationsschiene (3) ausgebildet ist, den Schlitten (4) in Richtung der Translationsrichtung (10) und/oder entgegengesetzt zu der Translationsrichtung (10) zu bewegen, und/oder wobei die Translationsrichtung (10) eine Krümmung aufweisen kann.
S6. System (1) gemäß einer der vorstehenden Ausführungsformen, umfassend eine Halteschiene (2), welche ausgebildet ist, das Werkstück (6) zu halten.
S7. System (1) gemäß der vorstehenden Ausführungsform mit Merkmalen von S6, wobei die Halteschiene (2) eine Haltefläche (7) aufweist und ausgebildet ist, das Werkstück (6) in einer Translationsebene beabstandet von der Haltefläche (7), insbesondere kontaktlos, zu halten.
S8. System (1) gemäß einer der vorstehenden Ausführungsformen, wobei das Mitnehmerelement (5) ausgebildet ist, an einer Kante des Werkstücks (6) zur Anlage zu kommen.
S9. System (1) gemäß einer der vorstehenden Ausführungsformen mit Merkmalen von S3, umfassend einen zweiten Schlitten, welcher ein weiteres Mitnehmerelement aufweist und/oder neben dem ersten Schlitten (4) an der Translationsschiene (3) angeordnet ist.
S10. System (1) gemäß einer der vorstehenden Ausführungsformen, mit den Merkmalen von S9, wobei das Mitnehmerelement (5) und das weitere Mitnehmerelement zueinander ausgerichtet sind.
S11. System (1) gemäß einer der vorstehenden Ausführungsformen, wobei das Mitnehmerelement (5) eine erste Aufnahmefläche (8) aufweist.
S12. System (1) gemäß einer der vorstehenden Ausführungsformen, mit Merkmalen von S11, wobei die erste Aufnahmefläche (8) zu einer Kante des Werkstücks (6), insbesondere parallel zu einer Kante des Werkstücks (6), ausgerichtet ist.
S13. System (1) gemäß einer der vorstehenden Ausführungsformen, mit Merkmalen von S11, wobei eine Flächennormale der ersten Aufnahmefläche (8) parallel zu einer Translationsrichtung (10) des ersten Schlittens (4) verläuft.
S14. System (1) gemäß einer der vorstehenden Ausführungsformen, mit Merkmalen von S11, wobei die erste Aufnahmefläche (8) als Vertiefung, insbesondere als eine rechteckige Vertiefung, in dem Mitnehmerelement (5) ausgebildet ist.
S15. System (1) gemäß einer der vorstehenden Ausführungsformen, mit den Merkmalen von S9 und S11, wobei das weitere Mitnehmerelement eine zweite Aufnahmefläche aufweist, wobei die erste Aufnahmefläche (8) und die zweite Aufnahmefläche ein Formnest bilden, um das Werkstück (6) an gegenüberliegenden Werkstückkanten (19,20) zu halten.
S16. System (1) gemäß einer der vorstehenden Ausführungsformen, mit den Merkmalen von S9, wobei das Mitnehmerelement (5) und das weitere Mitnehmerelement in Bezug auf die Translationsrichtung (10) spiegelbildlich identisch zueinander ausgebildet sind.
S17. System (1) gemäß einer der vorstehenden Ausführungsformen mit den Merkmalen von S15, wobei das Formnest einen Aufnahmebereich für das Werkstück (6) bildet, wobei das Formnest zumindest teilweise eine Umrisskante des Werkstücks (6) abbildet und/oder ausgebildet ist, an einem Punkt des Werkstücks (6) zur Anlage zu kommen.
S18. System (1) gemäß einer der vorstehenden Ausführungsformen, wobei der erste Schlitten (4) ein Montageelement (9) aufweist, welche ausgebildet ist, das Mitnehmerelement (5) zu halten.
S19. System (1) gemäß einer der vorstehenden Ausführungsformen mit den Merkmalen von S18, wobei das Montageelement (9) und das Mitnehmerelement (5) formschlüssig, kraftschlüssig und/oder trennbar miteinander verbunden sind.
S20. System (1) gemäß einer der vorstehenden Ausführungsformen mit den Merkmalen von S9, wobei der zweite Schlitten ein weiteres Montageelement aufweist, welches ausgebildet ist, das weitere Mitnehmerelement zu halten, und/oder wobei das weitere Montageelement und das weitere Mitnehmerelement formschlüssig, kraftschlüssig und/oder trennbar miteinander verbunden sind.
S21. System (1) gemäß einer der vorstehenden Ausführungsformen, wobei der erste Schlitten (4) und/oder das Mitnehmerelement ein Sekundäranschlagelement (11) umfasst, welches ausgebildet ist, an dem Werkstück (6) zur Anlage zu kommen.
S22. System (1) gemäß einer der vorstehenden Ausführungsformen mit den Merkmalen von S21, wobei das Sekundäranschlagelement (11) in einer Halteposition fixiert ist.
S23. System (1) gemäß einer der vorstehenden Ausführungsformen mit den Merkmalen von S21, wobei das Sekundäranschlagelement (11) ein Federelement aufweist, welches ausgebildet ist, das Sekundäranschlagelement (11) gegenüber dem Mitnehmerelement (5) gefedert, insbesondere überfedert, beweglich zu lagern.
S24. System (1) gemäß einer der vorstehenden Ausführungsformen mit Merkmalen von S21, wobei das Sekundäranschlagelement (11) ausgebildet ist, das Werkstück (6) an einer Werkstückkante zu halten.
S25. System (1) gemäß einer der vorstehenden Ausführungsformen mit Merkmalen von S21, wobei das Sekundäranschlagelement (11) eine Sekundärhaltefläche (12) aufweist, welche zu einer Kante des Werkstücks (6), insbesondere parallel zu einer Kante des Werkstücks (6), ausgerichtet ist.
S26. System (1) gemäß einer der vorstehenden Ausführungsformen mit Merkmalen von S12 und S25, wobei die Sekundärhaltefläche (12) und die erste Aufnahmefläche (8) in einer Translationsebene winklig zueinander, insbesondere rechtwinklig zueinander angeordnet sind.
S27. System (1) gemäß einer der vorstehenden Ausführungsformen, wobei eine Kante des Werkstücks (6), durch einen Kantenpunkt gebildet ist, um das Werkstück (6) an einer gekrümmten Kante zu halten.
S28. System (1) gemäß einer der vorstehenden Ausführungsformen mit Merkmalen von S25, wobei die Sekundärhaltefläche (12) gekrümmt ausgebildet ist, um einer gekrümmten Kantenkontur des Werkstücks (6) zu folgen.
S29. System (1) gemäß einer der vorstehenden Ausführungsformen mit Merkmalen von S28, wobei eine erste Projektion der Sekundärhaltefläche (12) projiziert auf eine erste Projektionsebene, welche eine Flächennormale parallel zur Translationsrichtung (10) aufweist, einen Flächeninhalt größer Null aufweist, um eine Abstützung des Werkstücks (6) bezüglich von Beschleunigungskräften mit und/oder entgegengesetzt zu der Translationsrichtung (10) zu erreichen.
S30. System (1) gemäß einer der vorstehenden Ausführungsformen mit Merkmalen von S28, wobei eine zweite Projektion der Sekundärhaltefläche (12) projiziert auf einer zweite Projektionsebene mit einer Flächennormale, welche senkrecht zur Translationsrichtung (10) und parallel zu einer Werkstückkante verläuft, einen Flächeninhalt größer Null aufweist, um eine Abstützung des Werkstücks (6) entgegen von Beschleunigungskräften senkrecht zur Translationsrichtung (10) zu erreichen.
S31. System (1) gemäß einer der vorstehenden Ausführungsformen mit den Merkmalen von S21, wobei das Sekundäranschlagelement (11) quaderförmig ausgebildet ist.
S32. System (1) gemäß einer der vorstehenden Ausführungsformen mit den Merkmalen von S25, wobei eine Dicke des Sekundäranschlagelements (11) in Richtung einer Flächennormale der Sekundärhaltefläche (12) kleiner ist als eine weitere Dicke der des Sekundäranschlagelements (11) senkrecht zu der Flächennormale und senkrecht zu der Längsrichtung des Sekundäranschlagelements (11).
S33. System (1) gemäß einer der vorstehenden Ausführungsformen mit den Merkmalen von S21, umfassend ein weiteres Sekundäranschlagelement (13), welches ausgebildet ist, an dem Werkstück (6) zur Anlage zu kommen.
S34. System (1) gemäß einer der vorstehenden Ausführungsformen mit den Merkmalen von S25 und S33, wobei das weitere Sekundäranschlagelement (13) eine weitere Sekundärhaltefläche (14) aufweist, welche zu einer Kante des Werkstücks (6), insbesondere parallel zu einer Kante des Werkstücks (6), ausgerichtet ist, wobei die Sekundärhaltefläche (12) und die weitere Sekundärhaltefläche (14) ausgebildet sind, an gegenüberliegenden Seiten des Werkstücks (6) oder zumindest an winklig zueinander ausgerichteten Seiten des Werkstücks, zur Anlage zu kommen.
S35. System (1) gemäß einer der vorstehenden Ausführungsformen mit den Merkmalen von S34, wobei die Sekundärhaltefläche (12) und die weitere Sekundärhaltefläche (14) parallel zueinander ausgerichtet sind.
S36. System (1) gemäß einer der vorstehenden Ausführungsformen mit den Merkmalen von S34, wobei die Sekundärhaltefläche (12) und die weitere Sekundärhaltefläche (14) spiegelbildlich symmetrisch zueinander, insbesondere winklig zueinander, ausgerichtet sind.
S37. System (1) gemäß einer der vorstehenden Ausführungsformen mit den Merkmalen von S21, wobei das Sekundäranschlagelement (11) relativ zu dem Mitnehmerelement (5), insbesondere entlang einer Positionierachse (16), verschiebbar an dem Mitnehmerelement (5) angeordnet ist.
S38. System (1) gemäß einer der vorstehenden Ausführungsformen mit den Merkmalen von S37, wobei das Mitnehmerelement (5) ein Positionierelement (15) aufweist, welches ausgebildet ist, auf Basis einer externen Krafteinwirkung auf das Positionierelement (15) das Sekundäranschlagelement (11) entlang der Positionierachse (16) zu verschieben.
S39. System (1) gemäß einer der vorstehenden Ausführungsformen mit den Merkmalen von S38, wobei das Positionierelement (15) ausgebildet ist, das Sekundäranschlagelement (11) während einer Bewegung des ersten Schlittens (4) entlang der Translationsrichtung (10) zu verschieben.
S40. System (1) gemäß einer der vorstehenden Ausführungsformen mit den Merkmalen von S38, wobei das Positionierelement (15) ausgebildet ist, das Sekundäranschlagselement (11) in Bezug auf einen Referenzpunkt zu verschieben, um das Werkstück (6) in Bezug auf den Referenzpunkt auszurichten und/oder zu zentrieren.
S41. System (1) gemäß einer der vorstehenden Ausführungsformen mit den Merkmalen von S33, wobei das weitere Sekundäranschlagelement (13) relativ zu dem Mitnehmerelement (5), insbesondere entlang einer Positionierachse (16), verschiebbar an dem Mitnehmerelement (5) angeordnet ist.
S42. System (1) gemäß einer der vorstehenden Ausführungsformen mit den Merkmalen von S41, wobei das Mitnehmerelement (5) ein weiteres Positionierelement (17) aufweist, welches ausgebildet ist, auf Basis einer externen Krafteinwirkung auf das weitere Positionierelement (17) das weitere Sekundäranschlagelement (13) entlang der Positionierachse (16) zu verschieben.
S43. System (1) gemäß einer der vorstehenden Ausführungsformen mit den Merkmalen von S38, umfassend einen Hebel, welcher ausgebildet ist, an dem Positionierelement (15) zur Anlage zu kommen und das Positionierelement (15) entlang der Positionierachse (16) zu verschieben.
S44. System (1) gemäß einer der vorstehenden Ausführungsformen mit den Merkmalen von S3 und/oder S6 und S43, wobei der Hebel an der Halteschiene (2) und/oder der Translationsschiene (3) angeordnet ist.
S45. System (1) gemäß einer der vorstehenden Ausführungsformen mit den Merkmalen von S43, wobei der Hebel ausgebildet ist, taktil abzurollen, um an dem Positionierelement (15) zur Anlage zu kommen.
S46. System (1) gemäß einer der vorstehenden Ausführungsformen mit den Merkmalen von S42, umfassend einen weiteren Hebel, welcher ausgebildet ist, an dem weiteren Positionierelement (17) zur Anlage zu kommen und das weitere Positionierelement (17) entlang der Positionierachse (16) zu verschieben.
S47. System (1) gemäß einer der vorstehenden Ausführungsformen mit den Merkmalen von S3und/oder S6 und S43, wobei der weitere Hebel an der Halteschiene (2) und/oder der Translationsschiene (3) angeordnet ist.
S48. System (1) gemäß einer der vorstehenden Ausführungsformen mit den Merkmalen von S46, wobei der weitere Hebel ausgebildet ist, taktil abzurollen, um an dem weiteren Positionierelement (17) zur Anlage zu kommen.
S49. System (1) gemäß einer der vorstehenden Ausführungsformen, wobei die Translationsschiene (3) ausgebildet ist, den ersten Schlitten in Richtung einer Translationsrichtung zu bewegen.
S50. System (1) gemäß einer der vorstehenden Ausführungsformen, wobei die Translationsschiene (3) mit Merkmalen von S9, wobei die Translationsschiene (3) ausgebildet ist, den ersten Schlitten und den zweiten Schlitten in Richtung einer Translationsrichtung (10) zu bewegen und/oder wobei ein Abstand zwischen dem ersten Schlitten und dem zweiten Schlitten in Translationsrichtung (10) konstant ist.
S51. System (1) gemäß einer der vorstehenden Ausführungsformen mit den Merkmalen von S9 und S11, wobei der erste Schlitten und der zweite Schlitten zueinander in einem Abstand positionierbar sind, um eine erste Länge des Formnestes in Fahrtrichtung des ersten Schlitten und des zweiten Schlittens zu definieren.
S52. System (1) gemäß einer der vorstehenden Ausführungsformen mit den Merkmalen von S18, wobei der erste Schlitten (4) ein Trägerelement (21) umfasst, und wobei das Montageelement (9) an dem Trägerelement (21) angeordnet ist.
S53. S43. System (1) gemäß einer der vorstehenden Ausführungsformen mit den Merkmalen von S52, wobei das Montageelement (9) verschiebbar, insbesondere in Translationsrichtung (10) verschiebbar, an dem Trägerelement (21) angeordnet ist.
S54. System (1) gemäß einer der vorstehenden Ausführungsformen, umfassen eine Mehrzahl von Schlitten, welche in einer Reihe an der Translationsschiene (3) angeordnet sind, wobei die Translationsschiene (3) ausgebildet ist, die einzelnen Schlitten der Mehrzahl von Schlitten hintereinander in einer Reihe entlang der Translationsrichtung (10) zu bewegen.
S55. System (1) gemäß einer der vorstehenden Ausführungsformen mit den Merkmalen von S54, wobei die Translationsschiene (3) ausgebildet ist, die Schlitten der Mehrzahl von Schlitten zueinander gleichförmig zu bewegen und/oder die Schlitten paarweise gleichförmig zueinander zu bewegen.
S56. System (1) gemäß einer der vorstehenden Ausführungsformen mit den Merkmalen von S17, wobei jeweils zwei Schlitten der Mehrzahl von Schlitten ausgebildet sind, ein Werkstück (6) zu halten und sich synchron, insbesondere mit gleichbleibendem Abstand zueinander, zu bewegen.
S57. System (1) gemäß einer der vorstehenden Ausführungsformen, wobei die Translationsschiene (3) ausgebildet ist, den ersten Schlitten (4) auf einer geschlossenen Bahn zu bewegen.
S58. System (1) gemäß einer der vorstehenden Ausführungsformen mit den Merkmalen von S57, wobei die Bahn in einer ersten Raumrichtung abschnittsweise gerade und/oder abschnittsweise gekrümmt ist.
S59. System (1) gemäß einer der vorstehenden Ausführungsformen mit den Merkmalen von S58, wobei die Bahn in einer zweiten Raumrichtung abschnittsweise gerade und/oder abschnittsweise gekrümmt ist.
S60. System (1) gemäß einer der vorstehenden Ausführungsformen mit einem Sensor, wobei der Sensor ausgebildet ist, eine physikalische Messgröße als Sensordaten zu erfassen.
S61. System (1) gemäß einer der vorstehenden Ausführungsformen mit einem Steuermodul, welches ausgebildet ist, eine Position des Schlittens auf der Translationsschiene (3) anzupassen.
S62. System (1) gemäß einer der vorstehenden Ausführungsformen mit den Merkmalen von S61, wobei das Steuermodul ausgebildet ist, die relative Position des ersten Schlittens in Bezug auf zumindest einen weiteren auf der Schiene angeordneten Schlitten mittels einer relativen Translation des ersten Schlittens bezüglich des zumindest eines weiteren Schlittens anzupassen.
S63. System (1) gemäß einer der vorstehenden Ausführungsformen mit den Merkmalen von S62, wobei das Steuermodul ausgebildet ist, die Position des ersten Schlittens in einem kontinuierlichen Bereich auf der Translationsschiene (3) zu variieren, um einen beliebigen Abstand zwischen zwei an der Translationsschiene (3) zueinander angrenzend angeordneten Schlitten einzustellen.
S64. System (1) gemäß einer der vorstehenden Ausführungsformen mit den Merkmalen von S62, wobei das Steuermodul ausgebildet ist, die Positionsanpassung des Schlittens unabhängig von einer weiteren Bewegung des Schlittens entlang der Translationsschiene (3) auszuführen.
S65. System (1) gemäß einer der vorstehenden Ausführungsformen mit den Merkmalen von S60 und S61, wobei das Steuermodul ausgebildet ist, die Position des Schlittens auf Basis der Sensordaten anzupassen.
S66. System (1) gemäß einer der vorstehenden Ausführungsformen mit den Merkmalen von S65, wobei das Steuermodul ausgebildet ist, eine Simulation durchzuführen um Simulationsdaten zu erzeugen und anhand der Simulationsdaten die Position des Schlittens auf der Schiene anzupassen.
S67. System (1) gemäß einer der vorstehenden Ausführungsformen mit den Merkmalen von S61, wobei das System (1) einen Positionsmesssensor aufweist, welcher ausgebildet ist, Positionsdaten des Schlittens zu erfassen und das Steuermodul ausgebildet ist, anhand der Positionsdaten die Position des Schlittens anzupassen, um eine ursprünglich eingestellte Position nachzustellen.
S68. System (1) gemäß einer der vorstehenden Ausführungsformen mit den Merkmalen von S66, wobei die Simulation eine Temperaturkompensation umfasst.
S69. System (1) gemäß einer der vorstehenden Ausführungsformen mit den Merkmalen von S7, wobei die Halteschiene (2), ein Anziehungselement, insbesondere einen Vakuumkanal umfasst, welches ausgebildet ist, auf das Werkstück eine zumindest teilweise entgegen einer Flächennormale der Haltefläche gerichtete Kraft auf das Werkstück auszuüben.
S70. System (1) gemäß einer der vorstehenden Ausführungsformen mit den Merkmalen von S7, wobei die Halteschiene ein Abstoßungselement aufweist, welches ausgebildet ist, auf das Werkstück eine zumindest teilweise in Richtung einer Flächennormale der Haltefläche gerichtete Kraft auf das Werkstück auszuüben.
S71. System (1) gemäß einer der vorstehenden Ausführungsformen mit den Merkmalen von S70, wobei das Abstoßungselement eine Sonotrode umfasst, welche ausgebildet ist, eine Ultraschallwelle zu erzeugen, um das Werkstück (6) beabstandet an der Halteschiene (2) zu halten.
S72. System (1) gemäß einer der vorstehenden Ausführungsformen mit den Merkmalen von S69 und S70, wobei das Abstoßungselement, insbesondere die Sonotrode in das Anziehungselement, insbesondere den Vakuumkanal, integriert ist.
S73. System (1) gemäß einer der vorstehenden Ausführungsformen mit den Merkmalen von S72, wobei das Anziehungselement eine Länge aufweist, welche einem Verfahrabschnitt entspricht, über welchen das Werkstück (6) bewegbar ist, um das Werkstück (6) mittels der Schlitten von einer ersten Position zu einer zweiten Position zu bewegen.
S74. System (1) gemäß einer der vorstehenden Ausführungsformen mit den Merkmalen von S72, wobei das Anziehungselement ausgebildet ist, das Werkstück während des Bewegens von der ersten Position zu der zweiten Position kontinuierlich kontaktlos zu halten.
S75. System (1) gemäß einer der vorstehenden Ausführungsformen mit den Merkmalen von S3 und S6, wobei die Translationsschiene (3) parallel zu der Halteschiene (2) angeordnet ist.
S76. System (1) gemäß einer der vorstehenden Ausführungsformen mit den Merkmalen von S75, wobei die Translationsschiene (3) entlang eines Verfahrwegs des Werkstücks (6) parallel zu der Halteschiene (2), insbesondere seitlich parallel zu der Halteschiene (2), angeordnet ist.
S77. System (1) gemäß einer der vorstehenden Ausführungsformen mit den Merkmalen von S3, wobei der erste Schlitten (4) ausgebildet ist, von der Translationsschiene (3) passiv geführt zu werden.
S78. System (1) gemäß einer der vorstehenden Ausführungsformen mit den Merkmalen von S69, wobei das Anziehungselement eine Bernoullidüse umfasst, welche ausgebildet ist, einen Unterdruck zwischen dem Werkstück (6) und der Haltefläche zu erzeugen.
S79. System (1) gemäß einer der vorstehenden Ausführungsformen mit den Merkmalen von S70, wobei die Sonotrode ausgebildet ist, eine Ultraschallwelle zu erzeugen, um das Werkstück (6) kontaktlos beabstandet an der Haltefläche zu halten.
S80. System (1) gemäß einer der vorstehenden Ausführungsformen mit den Merkmalen vonS70, wobei das Abstoßungselement eine Abblasdüse umfasst, welche ausgebildet ist, den Luftdruck zwischen Werkstück (6) und dem Anziehungselement zu erhöhen, um das Werkstück (6) von einer Halteposition in eine Ablageposition zu bewegen. Wobei die Ablageposition in Bezug auf die Halteposition einen größeren Abstand zu dem Anziehungselement I, insbesondere der Haltefläche, aufweist.
S81. System (1) gemäß einer der vorstehenden Ausführungsformen, wobei das Mitnehmerelement aus einem Blech hergestellt ist.
S82. System (1) gemäß einer der vorstehenden Ausführungsformen mit den Merkmalen von S81, wobei das Blech eine Dicke in einem Bereich von 0,1 mm bis 10 mm, vorzugsweise in einem Bereich von 1 mm bis 5 mm, aufweist.
S83. System (1) gemäß einer der vorstehenden Ausführungsformen, wobei das Mitnehmerelement (5) ausgebildet ist, an einer ersten Ecke des Werkstücks (6) zur Anlage zu kommen.
S84. System (1) gemäß einer der vorstehenden Ausführungsformen mit den Merkmalen von S83, wobei das Mitnehmerelement (5) ausgebildet ist, an einer weiteren Ecke des Werkstücks (6) zur Anlage zu kommen, wobei die weitere Ecke der ersten Ecke gegenüberliegt und/oder wobei die Ecke und die weitere Ecke jeweils einen Kantenabschnitt parallel zur Translationsrichtung (10) und einen weiteren Kantenabschnitt senkrecht zur Translationsrichtung (10) aufweisen.
S85. System (1) gemäß einer der vorstehenden Ausführungsformen, umfassend einen Positionssensor, welcher an einer Aufnahmeposition der Halteschiene (2) angeordnet ist, wobei der Positionssensor ausgebildet, die Anwesenheit eines Werkstücks (6) an der Aufnahmeposition zu erfassen und/oder zu überwachen.
S86. System (1) gemäß einer der vorstehenden Ausführungsformen mit den Merkmalen von S85, wobei der Positionssensor ausgebildet ist, die Integrität des Werkstücks (6) zu erfassen und/oder zu überwachen.
S87. System (1) gemäß einer der vorstehenden Ausführungsformen mit den Merkmalen von S6, wobei die Halteschiene (2) ein Führungslager aufweist, welches ausgebildet ist, das Mitnehmerelement (5) zu führen und/oder zu halten, um ein Schwingen des Mitnehmerelements (5) während einer Bewegung zu dämpfen und/oder zu unterbinden.
S88. System (1) gemäß einer der vorstehenden Ausführungsformen mit den Merkmalen von S69, wobei die Halteschiene, insbesondere der Vakuumkanal, einen ersten Temperatursensor umfasst, welcher ausgebildet ist, eine Temperatur des Werkstücks (6) zu erfassen.
S89. System (1) gemäß einer der vorstehenden Ausführungsformen mit den Merkmalen von S3, wobei die Translationsschiene (3) einen zweiten Temperatursensor umfasst, welcher ausgebildet ist, eine Temperatur des Werkstücks (6) zu erfassen.
S90. System (1) gemäß einer der vorstehenden Ausführungsformen mit den Merkmalen von S88, der erste Temperatursensor ausgebildet ist, die Temperatur des Werkstücks (6) an einer Werkstückaufnahmeposition zu erfassen.
S91. System (1) gemäß einer der vorstehenden Ausführungsformen mit den Merkmalen von S88, wobei die Halteschiene, insbesondere der Vakuumkanal, einen dritten Temperatursensor umfasst, welcher ausgebildet ist, die Temperatur des Werkstücks (6) an einer Werkstückablageposition zu erfassen.
S92. System (1) gemäß einer der vorstehenden Ausführungsformen mit den Merkmalen von S89 und S90, wobei die Werkstückaufnahmeposition und die Werkstückablageposition in Translationsrichtung (10) beabstandet voneinander angeordnet sind.
S93. System (1) gemäß einer der vorstehenden Ausführungsformen mit den Merkmalen von S61, wobei das Steuermodul ausgebildet ist, Temperaturmessdaten von einem Temperatursensor zu empfangen und die Position des ersten Schlittens (4) und/oder des Mitnehmerelements (5) in Translationsrichtung (10) auf Basis der Temperaturmessdaten zu ändern
S94. System (1) gemäß einer der vorstehenden Ausführungsformen mit den Merkmalen von S93, wobei die Temperaturmessdaten die Temperatur des Werkstücks (6), zumindest eines Teils der Translationsschiene (3), zumindest eines Teils der Halteschiene (2), einer Werkstückablage, insbesondere eines Matrixcarriers, und/oder einer Werkstückaufnahme betreffen.
S95. System (1) gemäß einer der vorstehenden Ausführungsformen mit den Merkmalen von S93, wobei das Steuermodul ausgebildet ist, eine Längenausdehnung des Werkstücks (6), zumindest eines Teils der Translationsschiene (3), zumindest eines Teils der Halteschiene (2), einer Werkstückablage und/oder einer Werkstückaufnahme auf Basis der Temperaturmessdaten zu berechnen, um eine temperaturbedingte Längenänderung, insbesondere durch eine Bewegung des ersten Schlittens (4), zu kompensieren.
S96. System (1) gemäß einer der vorstehenden Ausführungsformen mit den Merkmalen von S21und S61, wobei das Steuermodul ausgebildet ist, Temperaturmessdaten von einem Temperatursensor zu empfangen und eine Position des Sekundäranschlagelements (11) auf Basis der Temperaturmessdaten zu verändern, um eine temperaturbedingte Längenänderung des Werkstücks (6) zu kompensieren.
S97. System (1) gemäß einer der vorstehenden Ausführungsformen mit den Merkmalen von S61, wobei das Steuermodul ausgebildet ist, Längenänderungsdaten von einem Längensensor und/oder einem Bildverarbeitungsmodul zu empfangen und die Position des ersten Schlittens (4) und/oder des Mitnehmerelements (5) in Translationsrichtung (10) auf Basis der Längenmessdaten zu ändern, um eine Längenänderung des Werkstücks (6) zu kompensieren.
S98. System (1) gemäß einer der vorstehenden Ausführungsformen mit den Merkmalen von S21und S61, wobei das Steuermodul ausgebildet ist, Längenmessdaten von einem Längensensor und/oder einem Bildverarbeitungsmodul zu empfangen und eine Position des Sekundäranschlagelements (11) auf Basis der Längenmessdaten zu verändern, um eine Längenänderung des Werkstücks (6) zu kompensieren.
S99. System (1) gemäß einer der vorstehenden Ausführungsformen mit den Merkmalen von S3 und S6, umfassend eine weitere Translationsschiene, wobei die Translationsschiene (3) seitlich an der Halteschiene (2) angeordnet ist, und wobei die weitere Translationsschiene seitlich und gegenüberliegend der Translationsschiene (3) an der Halteschiene (2) angeordnet ist, um die Halteschiene (2) zwischen der Translationsschiene (3) und der weiteren Translationsschiene anzuordnen.
S100. System (1) gemäß einer der vorstehenden Ausführungsformen mit den Merkmalen von S3 und S6, umfassend eine weitere Halteschiene (18), wobei die Translationsschiene (3) seitlich an der Halteschiene (2) angeordnet ist, und wobei die weitere Halteschiene (18) seitlich und gegenüberliegend der Halteschiene (2) an der Translationsschiene (3) angeordnet ist, um die Translationsschiene (3) zwischen der Halteschiene (2) und der weiteren Halteschiene (18) anzuordnen.
S101. System (1) gemäß einer der vorstehenden Ausführungsformen mit den Merkmalen von S70, wobei das Abstoßungselement ein Düsenluftlagerelement aufweist, wobei das Düsenluftlagerelement ausgebildet ist, das Werkstück (6) von der Haltefläche (7) mittels eines Überdrucks, insbesondere mittels eines Luftstroms abzustoßen.
S102. System (1) gemäß einer der vorstehenden Ausführungsformen mit den Merkmalen von S7 und S69, wobei das Anziehungselement ausgebildet ist, das Werkstück (6) zu der Haltefläche (7) hin anzuziehen.
S103. System (1) gemäß einer der vorstehenden Ausführungsformen mit den Merkmalen von S101 und S102, umfassend ein Steuermodul, welches ausgebildet ist, das Anziehungselement, insbesondere den Vakuumkanal, und das Abstoßungselement, insbesondere das Düsenluftlagerelement, derart zu steuern, dass das Werkstück (6) in einem Abstand zu der Haltefläche (7) gehalten wird.
S104. System (1) gemäß einer der vorstehenden Ausführungsformen mit den Merkmalen von S70 und S102, umfassend ein Steuermodul, welches ausgebildet ist, den Vakuumkanal und die Sonotrode derart zu steuern, dass das Werkstück (6) in einem Abstand zu der Haltefläche (7) gehalten wird.
S105. System (1) gemäß einer der vorstehenden Ausführungsformen mit den Merkmalen von S7, wobei die Halteschiene (2) ein Luftfilmelement aufweist, wobei das Luftfilmelement ausgebildet ist, einen Luftfilm zwischen dem Werkstück (6) und der Haltefläche (7) zu erzeugen.
S106. System (1) gemäß einer der vorstehenden Ausführungsformen mit den Merkmalen von S7, wobei die Halteschiene (2) ein Magnetelement umfasst, welches ausgebildet ist, das Werkstück (6) magnetisch in Richtung der Haltefläche (7) zu ziehen.
S107. System (1) gemäß einer der vorstehenden Ausführungsformen mit den Merkmalen von S105 und S106, umfassend ein Steuermodul, welches ausgebildet ist, das Luftfilmelement und das Magnetelement derart zu steuern, dass das Werkstück (6) in einem Abstand zu der Haltefläche (7) gehalten wird.
S108. System (1) gemäß einer der vorstehenden Ausführungsformen mit den Merkmalen von S69, umfassend ein Steuermodul, welches ausgebildet ist, den Vakuumkanal derart zu steuern, dass das Werkstück (6) in einem Abstand zu der Haltefläche (7) gehalten wird, wobei die Gravitation der durch den Vakuumkanal erzeugten Haltekraft entgegenwirkt.
S109. System (1) gemäß einer der vorstehenden Ausführungsformen, wobei in Richtung der Translationsrichtung (10) eine Aufnahmeposition, an welcher das Werkstück (6) durch das System aufnehmbar ist, und eine Ablageposition an welcher das Werkstück (6) durch das System ablegbar ist, definiert sind.
S110. System (1) gemäß einer der vorstehenden Ausführungsformen mit den Merkmalen von S104, umfassend ein Steuermodul, welches ausgebildet ist, Sensordaten zu empfangen, welche eine Positionsänderung der Aufnahmeposition und/oder eine Positionsänderung der Ablageposition anzeigen, und wobei das Steuermodul ferner ausgebildet ist, den ersten Schlitten (4) auf Basis der Sensordaten zu verschieben, um eine zu der Aufnahmeposition und/oder der Ablageposition kongruente Schlittenposition zu erreichen, respektive das Formnest zu dem Werkstück (6) auszurichten.
5111. System (1) gemäß einer der vorstehenden Ausführungsformen, wobei das Mitnehmerelement (3) ausgebildet ist, das Werkstück (6) gegen Beschleunigungskräfte abzustützen.
S112. System (1) gemäß einer der vorstehenden Ausführungsformen, wobei das Mitnehmerelement (3) ausgebildet ist, drucklos an dem Werkstück (6) zur Anlage zu kommen.
S113. System (1) gemäß einer der vorstehenden Ausführungsformen, umfassend ein Steuermodul, wobei das Steuermodul ausgebildet ist, das Mitnehmerelement (5) mittels Bewegung des ersten Schlittens (4) an dem Werkstück (6) zur Anlage zu bringen und das Auftreten einer Klemmkraft zwischen Werkstück (6) und Mitnehmerelement (5) zu unterbinden.
S114. System (1) gemäß einer der vorstehenden Ausführungsformen mit den Merkmalen von S21 und S43, umfassend ein Steuermodul, wobei das Steuermodul ausgebildet ist, das Sekundäranschlagelement (11) mittels Bewegen des Hebels an dem Werkstück (6) zur Anlage zu bringen und das Auftreten einer Klemmkraft zwischen dem Werkstück (6) und dem Sekundäranschlagelement (11) zu unterbinden.
S115. System (1) gemäß einer der vorstehenden Ausführungsformen, wobei das Mitnehmerelement (5) ausgebildet ist, in eine Ausnehmung des Werkstücks einzugreifen.
S116. System (1) gemäß einer der vorstehenden Ausführungsformen mit den Merkmalen von S115, wobei das Mitnehmerelement (5) ausgebildet ist, zumindest teilweise an einer Innenkante der Ausnehmung zur Anlage zukommen.
Im Folgenden werden Verfahrensausführungsformen besprochen. Diese Ausführungsformen werden mit dem Buchstaben "V", gefolgt von einer Zahl, abgekürzt. Immer, wenn hier auf "Verfahrensausführungsformen" Bezug genommen wird, sind diese Ausführungsformen gemeint.
V1. Verfahren (1) zum Halten eines Werkstücks (6) mit einem System gemäß einem der vorstehenden Ausführungsformen.

### Kurze Beschreibung der Figuren

Die vorliegende Erfindung wird nun unter Bezugnahme auf die beigefügten Figuren beschrieben, die Ausführungsformen der Erfindung veranschaulichen. Diese Ausführungsformen sollen die vorliegende Erfindung nur beispielhaft darstellen, aber nicht einschränken.
Fig. 1 zeigt eine schematische Darstellung einer Ausführungsform der vorliegenden Erfindung;
Fig. 2 zeigt eine schematische Darstellung einer weiteren Ausführungsform der vorliegenden Erfindung;
Fig. 3 zeigt eine schematische Darstellung einer weiteren Ausführungsform der vorliegenden Erfindung; und
Fig. 4 zeigt eine schematische Darstellung einer weiteren Ausführungsform der vorliegenden Erfindung.

### Detaillierte Beschreibung der Figuren

Es wird darauf hingewiesen, dass nicht alle Zeichnungen alle Bezugszeichen tragen. Stattdessen sind in einigen der Zeichnungen einige der Bezugszeichen der Kürze und Einfachheit der Darstellung halber weggelassen worden. Ausführungsformen der vorliegenden Erfindung werden nachfolgend unter Bezugnahme auf die beigefügten Zeichnungen beschrieben.

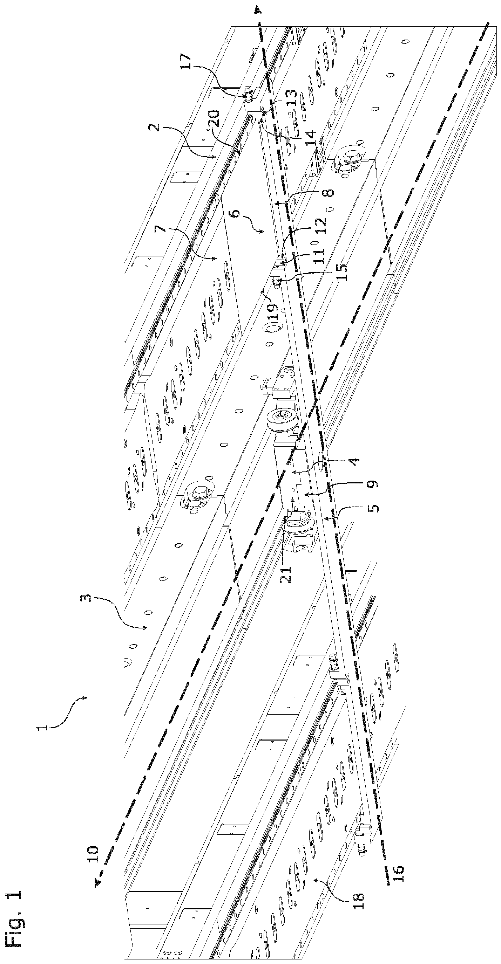

Fig. 1 ist eine schematische Darstellung einer Ausführungsform des Systems 1 zum Halten eines Werkstücks 6. Hierbei kann das Werkstück 6 an der Halteschiene 2, insbesondere ausgerichtet zu einer Haltefläche 7, gehalten werden. Das Werkstück 6 und die Halteschiene 2 sind vorteilhafterweise derart zueinander orientiert, dass eine auf das Werkstück 6 wirkende Gewichtskraft mit einer Flächennormale der Haltefläche 7 einen Winkel kleiner gleich 90° einschließt. Mit anderen Worten wird das Werkstück 6 hängend an der Halteschiene 2 gehalten. Ein Schlitten 4 kann an einer Translationsschiene bewegt werden, um den Schlitten 4 relativ zu dem Werkstück 6 und/oder einer Werkstückaufnahmeposition zu bewegen. Entsprechend kann der Schlitten 4 zum Verschieben des Werkstücks 6 entlang einer Translationsrichtung 10 bewegt werden. Der Schlitten 2 kann ein Mitnehmerelement 5 aufweisen, welches ausgebildet sein kann, auf das Werkstück 6 eine Kraft zu übertragen, um das Werkstück entlang der Translationsrichtung 10 zu bewegen. Hierzu kann das Mitnehmerelement 5 an dem Werkstück 6 zur Anlage kommen. Das Mitnehmerelement 5 kann durch eine Bewegung des Schlittens gesteuert werden. Hierbei kann ein entsprechendes Anfahrprofil mit vorbestimmten Beschleunigungen und Geschwindigkeiten durchgeführt werden, um eine vorbestimmte Positionierungspräzision zu erreichen und/oder auf das Werkstück 6 wirkende Beschleunigungen zu begrenzen. Vorteilhafterweise kann eine Stoßbeschleunigung minimiert sein und/oder ein vorbestimmtes Beschleunigungsprofil mit vorbestimmten Beschleunigungsgradienten erreicht werden. Das Werkstück 6 kann über das Mitnehmerelement 5 zangenartig an Kanten des Werkstücks 6 fixiert werden. Diese Werkstückkanten können auch innenliegend sein (nicht gezeigt). Beispielsweise Werkstückkanten einer Werkstückausnehmung.

Das Mitnehmerelement 5 kann ein Sekundäranschlagelement 11 aufweisen, über welches das Mitnehmerelement 5 an dem Werkstück 6 zur Anlage kommt. Das Sekundäranschlagelement 11 kann modular ausgebildet sein, um eine flexible Anpassung an eine Werkstückaußenkante zu erreichen.

Ferner kann das Sekundäranschlagelement 11 gegenüber einem Basisträgerelement des Mitnehmerelements 5 beweglich gelagert sein. Dadurch kann beispielsweise eine Positionierung einer Sekundärhaltefläche 12 sowohl in und/oder entgegen der Translationsrichtung 10 als auch entlang einer Positionierachse 16 realisiert sein. Das Sekundäranschlagelement 11 kann mit einer vorbestimmten Kraft auf das Werkstück 6 wirken, um ein Verschieben des Werkstücks 11 relativ zum Schlitten 4 bei einer Beschleunigung des Schlittens zu unterbinden.

Das Sekundäranschlagelement 11 kann mit einem Positionierelement 15 derart verbunden sein, dass eine Krafteinwirkung auf das Positionierelement 15 das Sekundäranschlagelement 11 entlang der Positionierachse 16 relativ zu dem Mitnehmerelement 5 und/oder dem Werkstück 6 bewegt. Dies kann eine Translation entlang der Positionierachse 16 und/oder eine Rotation um eine Drehachse des Positionierelements 15 sein. Insbesondere kann die Drehachse parallel zu der Positionierachse ausgerichtet sein. Das Positionierelement 15 kann drehbar und/oder verschiebbar an dem Mitnehmerelement 5 gelagert sein. Insbesondere kann das Positionierelement 15 gefedert gelagert sein. Damit kann bei einer Anlage des Sekundäranschlagelements 11 an dem Werkstück 6 mittels einer Spannung einer Feder eine Federkraft auf eine Kante des Werkstücks 6 ausgeübt werden.

Die Feder kann an dem Positionierelement 15, dem Mitnehmerelement 5 und/oder dem Sekundäranschlagelement 11 befestigt sein. Insbesondere kann das Positionierelement 15 zumindest teilweise innerhalb der Feder angeordnet sein.

Als Gegenlagerpunkt, -linie oder -fläche zu der über das Sekundäranschlagelement 11 auf das Werkstück 6 wirkende Kraft, kann das Werkstück an einer dem Sekundäranschlagelement 11 abgewandten Seite an dem Mitnehmerelement 5 zur Anlage kommen. Entsprechend kann das Werkstück an zwei voneinander abgewandten Flächen oder Kanten gehalten werden. Hierzu kann das Mitnehmerelement 5 eine Vertiefung (Aufnahmefläche 8) aufweisen, in welche das Werkstück 6 eingreift. Hierbei kann das Werkstück beabstandet von der Aufnahmefläche 8 angeordnet sein und an dem Sekundäranschlagelement 11 und einem entsprechend gegenüberliegenden Gegenlagerpunkt zur Anlage kommen. Hierbei kann ein weiteres Sekundäranschlagelement 13 vorgesehen sein und der Gegenlagerpunkt kann durch einen Kontakt an einer weiteren Sekundärhaltefläche 14 gebildet sein. Dieser Kontakt kann punktförmig, linienförmig oder flächig sein. Das Werkstück kann an den Sekundärhalteflächen 12, 14 durch eine Andruckkraft, Oberflächenreibung, Adhäsion oder einer Kombination der Vorgenannten gehalten werden. Das weitere Sekundäranschlagelement 13 kann spiegelsymmetrisch zu dem Sekundäranschlagelement 11 ausgebildet sein.

Insbesondere kann ferner ein weiteres Positionierelement 17 vorgesehen sein, welches spiegelsymmetrisch zu dem Positionierelement 15 angeordnet ist. Eine Symmetrieachse kann hier parallel zu der Translationsrichtung 10 verlaufen und mittig zu dem Werkstück 6 ausgerichtet sein (einen Mittelpunkt des Werkstücks 6 schneiden). Auch das weitere Positionierelement kann an dem Mitnehmerelement 5, insbesondere mittels einer Feder, gelagert sein. Vorteilhafterweise kann über das weitere Sekundäranschlagelement 13 eine gleichgroße und zu der über das Sekundäranschlagelement 11 auf das Werkstück 6 wirkende entgegengerichtete Kraft auf das Werkstück 6 wirken. Damit kann das Werkstück in einer Transportposition fixiert sein, sodass das Werkstück 6 und das Mitnehmerelement 5 und/oder das Sekundäranschlagelement 11 bei einer Translation und/oder einer Beschleunigung, insbesondere in Translationsrichtung 10, in Relation zueinander in gleichem Abstand verbleiben. Auch das weitere Positionierelement 17 kann an dem Mitnehmerelement 5 beweglich, insbesondere drehbar und/oder verschiebbar gelagert sein. Das Positionierelement 17 kann ferner mittels einer Feder gelagert sein. Das weitere Sekundäranschlagelement 13 kann insbesondere mittels der weiteren Sekundärhaltefläche 14 an einer weiteren Werkstückkante 20 zur Anlage kommen.

Gemäß der in Fig. 1 gezeigten Ausführungsform kann das Mitnehmerelement in Bezug auf den Schlitten symmetrisch ausgebildet sein, sodass Werkstücke an einer weiteren Halteschiene 18 geführt werden können. Hier kann der gleiche Haltemechanismus wie auch an der ersten Halteschiene 2 in Bezug auf das Werkstück 6 vorgesehen sein, um weitere Werkstücke parallel zu dem Werkstück 6 zu bewegen. Die Halteschiene 2, die weitere Halteschiene 18 und die Translationsschiene 3 können parallel zueinander verlaufen.

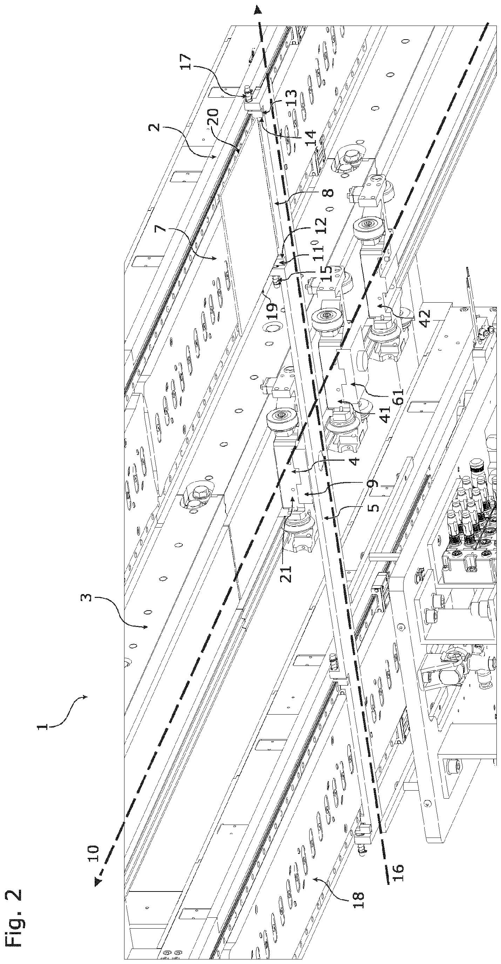

Fig. 2 ist eine schematische Darstellung einer Ausführungsform des Systems 1 zum Halten eines Werkstücks 6. Hierbei sind insbesondere drei Schlitten 4, 41, 42 gezeigt, welche in unterschiedlicher modularer Bestückung ausgeführt sind. Der Schlitten 4 umfasst ein Trägerelement 21, ein Montageelement 9 und ein Mitnehmerelement 5. Hierbei kann das Trägerelement 21 lösbar mit dem Montageelement 9 verbunden sein und/oder das Montageelement 9 kann lösbar mit dem Mitnehmerelement verbunden sein. Insbesondere kann jeweils eine Formschlussverbindung vorgesehen sein, welche eine Bewegung des jeweils aufgesetzten Teils (Montageelement 9 oder Mitnehmerelement 5) in zumindest einer Raumrichtung beschränkt. Beispielsweise kann das Montageelement 9 zumindest teilweise ein Negativprofil zu einer Oberflächenform des Trägerelements 21 aufweisen und entsprechend formschlüssig in dieses Eingreifen. Das Mitnehmerelement 5 kann drehbar an dem Montageelement 9 gelagert sein, um eine Ausrichtung des Mitnehmerelements 5 in Bezug auf eine Aufnahmeposition und/oder eine Ablageposition des Werkstücks 6 zu ermöglichen. Das Mitnehmerelement 5 kann bei einer Bewegung des Schlittens 4 derart an dem Montageelement 9 fixiert sein, dass eine voreingestellte Position des Mitnehmerelements 5 auf dem Montageelement 9, insbesondere in Bezug auf einen voreingestellten Winkel zwischen der Translationsrichtung 10 und einer Längsachse des Mitnehmerelements 5, konstant ist. In der gezeigten Ausführungsform verläuft die Längsachse des Mitnehmerelements 5 parallel zu der Positionierachse 16. Beispielsweise kann das Montageelement 61 eine zylindrisch geformte Aufnahmeerhebung sein, welche ausgebildet sein kann in eine passende Ausnehmung in dem Mitnehmerelement 5 einzugreifen. Damit kann die Aufnahmeerhebung eine Drehachse für das Mitnehmerelement 5 bilden.

Mittels der Montage des Montageelements 9 an dem Schlitten 4 und/oder mittels der Montage des Mitnehmerelements 5 an dem Montageelement kann ferner ein Abstand des Mitnehmerelements 5 zu der Halteschiene 2', insbesondere der Haltefläche 7 realisiert sein. Dadurch kann das Mitnehmerelement 5 passend zu einem Halteabstand des Werkstücks 6 an der Halteschiene eingestellt sein.

Das Sekundäranschlagelement 11 kann derart ausgebildet sein, dass das Werkstück über einen vorbestimmten Abstandstoleranzbereich in Richtung einer Flächennormale der Haltefläche 7 an dem Werkstück 6 zur Anlage kommen kann. Entsprechend kann das Werkstück 6 in diesem Abstandstoleranzbereich von der Haltefläche 7 beabstandet gehalten werden und das Sekundanschlagelement 11 kann an dem Werkstück 6 zur Anlage kommen. Insbesondere kann eine Höhe des Sekundäranschlagelements 11 in Richtung einer Flächennormale der Haltefläche 7 größer sein als eine Dicke des Werkstücks 6 in dieser Richtung.

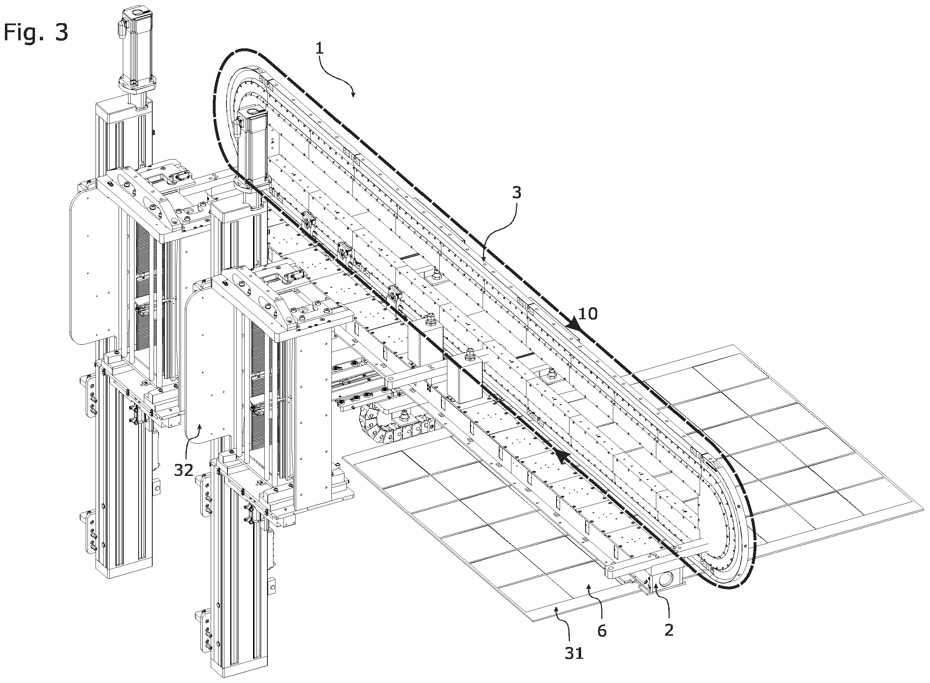

Fig. 3 ist eine schematische Darstellung einer Ausführungsform des Systems 1 zum Halten eines Werkstücks 6. Hierbei kann beispielsweise das Werkstück 6 von einer Ablageplattform 31 (beispielsweise ein Matrix-tray) mittels der Halteschiene 2 abgehoben und an dieser kontaktlos gehalten werden. Die Translationsschiene 3 kann als kontinuierlicher Ring ausgebildet sein. Hierbei können zum Werkstücktransport gerade Abschnitte vorgesehen sein und zur Rückführung der Schlitten können gekrümmte Abschnitte vorgesehen sein, um die Bahn zu schließen. Entsprechend kann eine Transporttrajektorie 10 geschlossen sein. Das System kann ferner ein Werkstückablagemodul 32 umfassen, Hierbei kann das Werkstück an einer vorbestimmten Ablagepositionen entlang der Transporttrajektorie von der Halteschiene abgelegt, insbesondere abgeblasen werden. Anschließend kann das Werkstück in dem Werkstückablagemodul 32 gehalten werden. Die Halteschiene 2 und die Translationsschiene 3 können zusammen verschiebbar angeordnet sein, um eine relative Position von Werkstückablagemodul 32 zu den Schienen (2, 3) zu verändern.

Die Halteschiene 2 und/oder die Translationsschiene 3 können modular ausgebildet sein, sodass mittels Verbindens einer Mehrzahl von Halteelementen, respektive Translationselementen eine Länge und/oder ein Verlauf der jeweiligen Schiene anpassbar sein kann. Ferner kann die Translationsschiene 2 eine Mehrzahl an Kurvenelementen umfassen, mit welchen eine Krümmung der Transporttrajektorie 10 anpassbar ist.

Die Translationstrajektorie 10 kann in der Richtung beliebig veränderbar sein. Insbesondere kann die Translationsschiene 2 ausgebildet sein die Schlitten während eines Pick&Placevorgangs entlang der Translationstrajektorie 10 vor und zurück zu bewegen (also entsprechend in Pfeilrichtung oder entgegen der gezeigten Pfeilrichtung).

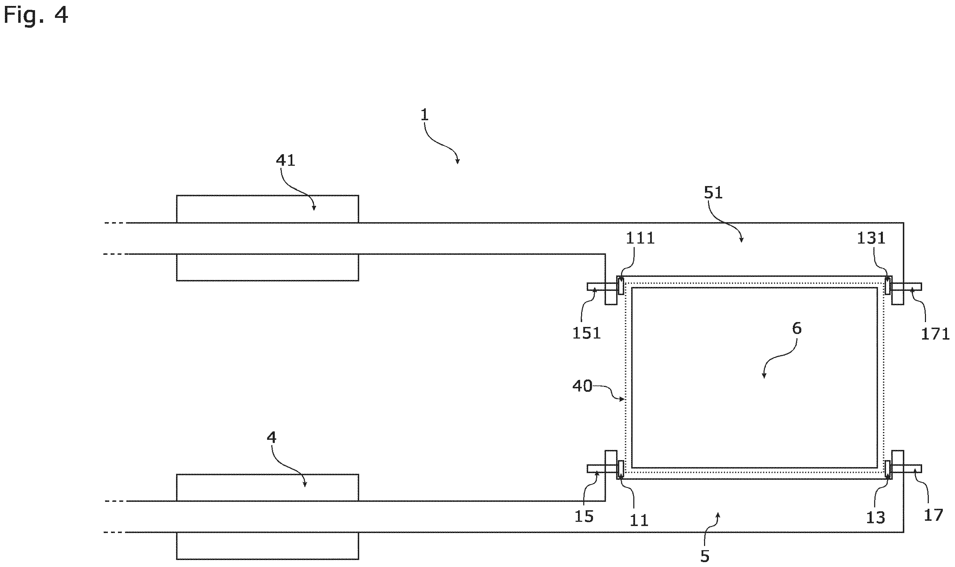

Fig. 4 zeigt ein Formnest 40 gebildet durch zwei zueinander ausgerichtete Mitnehmerelemente 5, 51. Das Mitnehmerelemente 5 kann an einem Schlitten 4 angeordnet sein und das weitere Mitnehmerelement 51 kann an einem zweiten Schlitten 41 angeordnet sein. Durch relatives Verschieben der Schlitten 4, 41 zueinander kann das Formnest 40 in einer Länge verändert werden. Hierbei kann der erste Schlitten 4 die Sekundäranschlagelemente 11, 13 umfassen und/oder der zweite Schlitten 41 kann die Sekundäranschlagelemente 111, 131 umfassen. Das Mitnehmerelement 5 kann Positionierelemente 15, 17 umfassen und das weitere Mitnehmerelement 51 kann Positionierelemente 151, 171 umfassen. Mit den Positionierelementen 15, 151, 17, 171 kann eine Breite des Formnests 40 einstellbar sein. Alternativ können lediglich die Sekundäranschlagelemente 11 und 111 und die Positionierelemente 15, 151 vorgesehen sein. Ferner können alternativ lediglich die Sekundäranschlagelemente 13, 131 und die Positionierelemente 17, 171 vorgesehen sein. Das Formnest 40 kann einer Fläche des Werkstücks 6 entsprechen. Gezeigte Abstände dienen zur deutlicheren Darstellung.

Während im Vorstehenden bevorzugte Ausführungsformen unter Bezugnahme auf die begleitenden Zeichnungen beschrieben worden sind, wird der Fachmann verstehen, dass diese Ausführungsformen ausschließlich zum Zwecke der Veranschaulichung bereitgestellt wurden, und keinesfalls so auszulegen sind, dass sie den Schutzbereich der vorliegenden Erfindung eingrenzen, der von den Ansprüchen definiert wird. Bezugszeichen und Buchstaben, die in Klammern in Ansprüchen erscheinen, die Merkmale identifizieren, die in Ausführungsformen beschrieben und in begleitenden Zeichnungen veranschaulicht werden, werden als ein Hilfsmittel für den Leser zur Exemplifizierung der beanspruchten Materie bereitgestellt. Der Einschluss solcher Bezugszeichen und Buchstaben darf nicht so interpretiert werden, dass dem Geltungsbereich der Ansprüche irgendwelche Einschränkungen auferlegt werden.

Jedes Mal, wenn ein relativer Ausdruck wie "ungefähr", "im Wesentlichen" oder "annähernd" in dieser Beschreibung angewandt wird, sollte ein solcher Ausdruck ebenfalls so ausgelegt werden, dass er auch den genauen Ausdruck einschließt. Das heißt, z. B. "im Wesentlichen gerade" sollte ebenfalls so ausgelegt werden, dass auch "(genau) gerade" eingeschlossen ist.

## Patentansprüche

1. System (1) zum Halten eines Werkstücks (6), umfassend einen ersten Schlitten (4), welcher ein Mitnehmerelement (5) aufweist, wobei das Mitnehmerelement (5) ausgebildet ist, an dem Werkstück (6) zur Anlage zu kommen.

2. System (1) nach Anspruch 1 umfassend eine Halteschiene (2), wobei die Halteschiene (2) eine Haltefläche (7) aufweist und ausgebildet ist, das Werkstück (6) in einer Translationsebene beabstandet von der Haltefläche (7) zu halten und wobei das Mitnehmerelement (5) ausgebildet ist, an einer Kante des Werkstücks (6) zur Anlage zu kommen.

3. System (1) gemäß einem der vorstehenden Ansprüche, wobei der erste Schlitten (4) ein Sekundäranschlagelement (11) umfasst, welches ausgebildet ist, an dem Werkstück (6) zur Anlage zu kommen, wobei das Sekundäranschlagelement (11) eine Sekundärhaltefläche (12) aufweist, welche zu einer Kante des Werkstücks (6) ausgerichtet ist, wobei das Mitnehmerelement (5) eine erste Aufnahmefläche (8) aufweist, und wobei die Sekundärhaltefläche (12) und die erste Aufnahmefläche (8) in einer Translationsebene winklig zueinander angeordnet sind.

4. System (1) gemäß Anspruch 3, wobei das Sekundäranschlagelement (11) relativ zu dem Mitnehmerelement (5) verschiebbar an dem Mitnehmerelement (5) angeordnet ist, und wobei das Mitnehmerelement (5) ein Positionierelement (15) aufweist, welches ausgebildet ist, auf Basis einer externen Krafteinwirkung auf das Positionierelement (15) das Sekundäranschlagelement (11) zu verschieben.

5. System (1) gemäß Anspruch 4, wobei das Positionierelement (15) ausgebildet ist, das Sekundäranschlagselement (11) in Bezug auf einen Referenzpunkt zu verschieben, um das Werkstück (6) in Bezug auf den Referenzpunkt auszurichten und/oder zu zentrieren.

6. System (1) gemäß Anspruch 5, umfassend einen Hebel, welcher ausgebildet ist, an dem Positionierelement (15) zur Anlage zu kommen und das Positionierelement (15) entlang einer Positionierachse (16) zu verschieben.

7. System (1) nach einem der vorstehenden Ansprüche, umfassend eine Translationsschiene (3), wobei der Schlitten (4) an der Translationsschiene (3) angeordnet ist und wobei die Translationsschiene (3) ausgebildet ist, den Schlitten (4) entlang einer Translationsrichtung zu bewegen.

8. System (1) nach Anspruch 7, umfassend einen zweiten Schlitten, wobei der erste Schlitten (4) und der zweite Schlitten ausgebildet sind, ein Werkstück (6) zu halten und die Translationsschiene ausgebildet ist, den ersten Schlitten (4) und den zweiten Schlitten mit gleichbleibendem Abstand der Schlitten zueinander, zu bewegen.

9. System (1) nach einem der vorstehenden Ansprüche, umfassend eine Halteschiene (2), welche ausgebildet ist, das Werkstück (6) zu halten, wobei die Halteschiene (2) eine Haltefläche (7) aufweist und ausgebildet ist, das Werkstück (6) in einer Translationsebene beabstandet von der Haltefläche (7) zu halten.

10. System (1) nach einem der vorstehenden Ansprüche, umfassend ein Steuermodul, welches ausgebildet ist, eine Position des ersten Schlittens (4) anzupassen und die relative Position des ersten Schlittens in Bezug auf zumindest einen weiteren auf der Schiene angeordneten Schlitten mittels einer relativen Translation des ersten Schlittens bezüglich des zumindest eines weiteren Schlittens anzupassen.

11. System (1) nach einem Anspruch 10, umfassend einen Sensor, welcher ausgebildet ist, eine physikalische Messgröße als Sensordaten zu erfassen, und wobei das Steuermodul ausgebildet ist, die Position des ersten Schlittens (4) auf Basis der Sensordaten anzupassen.

12. System (1) gemäß Anspruch 3, wobei das Sekundäranschlagelement (11) ein Federelement aufweist, welches ausgebildet ist, das Sekundäranschlagelement (11) gegenüber dem Mitnehmerelement (5) gefedert beweglich zu lagern.

13. System (1) gemäß Anspruch 4, umfassend einen Hebel, welcher ausgebildet ist, an dem Positionierelement (15) zur Anlage zu kommen und das Positionierelement (15) entlang der Positionierachse (16) zu verschieben. wobei der Hebel ausgebildet ist, taktil abzurollen, um an dem Positionierelement (15) zur Anlage zu kommen.

14. System (1) gemäß Anspruch 3, umfassend ein weiteres Sekundäranschlagelement (13), welches ausgebildet ist, an dem Werkstück (6) zur Anlage zu kommen, wobei das weitere Sekundäranschlagelement (13) eine weitere Sekundärhaltefläche (14) aufweist, welche zu einer Kante des Werkstücks (6), ausgerichtet ist, wobei die Sekundärhaltefläche (12) und die weitere Sekundärhaltefläche (14) ausgebildet sind an winklig zueinander ausgerichteten Seiten des Werkstücks, zur Anlage zu kommen.

15. System (1) gemäß Anspruch 8, wobei die Translationsschiene (3) ausgebildet ist, den ersten Schlitten (4) und den zweiten Schlitten in Richtung einer Translationsrichtung (10) zu bewegen, wobei der erste Schlitten und der zweite Schlitten zueinander in einem Abstand positionierbar sind, um eine erste Länge eines Formnestes in Fahrtrichtung des ersten Schlittens (4) und des zweiten Schlittens zu definieren.
